# EUROPEAN PATENT APPLICATION

(11) **EP 2 043 134 A1**
(43) Date of publication of application: **01.04.2009**
(21) Application number: 07767841.5
(22) Date of filing: 28.06.2007
(51) Int. Cl.: H01L 21/027, G03F 7/20

(54) **MAINTENANCE METHOD, EXPOSURE METHOD AND APPARATUS AND DEVICE MANUFACTURING METHOD**

(30) Priority: 30.06.2006 JP 2006182561
(71) Applicant: Nikon Corporation, Chiyoda-ku Tokyo 100-8331 (JP)
(72) Inventor: YODA, Yasushi, Tokyo 100-8331 (JP)
(74) Representative: Hooiveld, Arjen Jan Winfried
(86) International application number: PCT/JP2007/063049
(87) International publication number: WO 2008/001871

(57) **Abstract**

There is provided a maintenance method capable of efficiently maintaining an exposure apparatus performing exposure by the liquid immersion method. The method for maintaining the exposure apparatus which exposes a substrate with an exposure light via a projection optical system (PL) and a liquid (1) of an liquid immersion area (AR2) includes: a moving step of arranging a measuring table (MTB) to be opposite to a nozzle member (30) forming the liquid immersion area (AR2); an accumulating step of supplying the liquid (1) onto the measuring table (MTB) by using the nozzle member (30), and accumulating the supplied liquid in a cylinder portion (91); and a cleaning step of jetting the liquid (1) accumulated in the accumulating step from a jet nozzle portion (90) to an area including at least a part of a liquid contact portion, which has a possibility of coming into contact with the liquid (1), during liquid immersion exposure.

## Description

### TECHNICAL FIELD

The present invention relates to a maintenance technique for an exposure apparatus which exposes a substrate with an exposure light via a liquid. The present invention also relates to an exposure technique and a technique for producing a device using the maintenance technique.

### BACKGROUND ART

A microdevice (electronic device) which includes a semiconductor device, a liquid crystal display device, etc. is produced by the so-called photolithography technique wherein a pattern, which is formed on a mask such as a reticle, is transferred onto a substrate such as a wafer which is coated with a resist (photosensitive material). In order to transfer the pattern on the mask onto the substrate via a projection optical system in the photolithography step, those used as the exposure apparatus include an exposure apparatus (so-called stepper) of the reduction projection type of the step-and-repeat system, an exposure apparatus (so-called scanning stepper) of the reduction projection type of the step-and-scan system, etc.

As for the exposure apparatus of this type, it has been carried out to shorten the wavelength of the exposure light and increase the numerical aperture (NA) of the projection optical system (realize the large NA) in order to respond to such a request that the higher resolution (resolving power) is demanded year by year as the pattern becomes fine and minute in accordance with the realization of the high integration of the semiconductor device or the like. However, when the wavelength of the exposure light is shortened and NA is increased, then the resolution of the projection optical system is improved, while the depth of focus is consequently decreased and narrowed. Therefore, if such a situation is continued, then the depth of focus is too narrowed and it is feared that the focus margin may be insufficient during the exposure operation.

In view of the above, an exposure apparatus, which utilizes the liquid immersion method, has been developed in order to provide such a method that the exposure wavelength is substantially shortened and the depth of focus is widened as compared with those obtained in the air (see, for example, International Publication No. 99/49504). In the liquid immersion method, the exposure is performed in such a state that the liquid immersion area is formed by filling a space between the lower surface of the projection optical system and a surface of the substrate (substrate surface) with a liquid including water, organic solvents, etc. Accordingly, the resolution can be improved and the depth of focus can be magnified about n times by utilizing the fact that the wavelength of the exposure light is 1/n-fold in the liquid as compared with the wavelength in the air (n represents the refractive index of the liquid, which is, for example, about 1.2 to 1.6).

### DISCLOSURE OF THE INVENTION

### Task to Be Solved by the Invention:

In a case that the exposure process is performed by using the liquid immersion method as described above, then the exposure is performed for the substrate while supplying the liquid to a liquid immersion area formed between the projection optical system and the substrate from a certain or predetermined liquid supply mechanism, and the liquid of a liquid immersion area is recovered by a certain or predetermined liquid recovery mechanism. However, it is feared that a minute foreign matter (particles) including the resist residue, etc. might be gradually accumulated during the exposure based on the liquid immersion method on a portion which comes into contact with the liquid (liquid contact portion), for example, on the flow passages for the liquid of the liquid supply mechanism and the liquid recovery mechanism. There is such a possibility that the foreign matter accumulated as described above might enter into and mix with the liquid again and might adhere to the surface of the substrate as the exposure objective during the exposure to be performed thereafter, and the foreign matter might become a factor of the defect such as the shape deficiency or unsatisfactory shape of the pattern to be transferred, etc.

Therefore, it is desirable that the foreign matter accumulated on the liquid flow passages of the liquid supply mechanism and the liquid recovery mechanism, etc. is efficiently removed by any method, for example, during the periodic maintenance for the exposure apparatus.
Taking the foregoing circumstances into consideration, an object of the present invention is to provide an efficient maintenance technique for an exposure apparatus which performs the exposure by the liquid immersion method.

Another object of the present invention is to provide an exposure technique and a technique for producing a device to which the maintenance technique is applicable with ease.
Still another object of the present invention is to provide a cleaning technique, an exposure technique, and a technique for producing a device, wherein it is possible to easily clean or wash the liquid contact portion which comes into contact with the liquid.

### Solution for the Task:

A first maintenance method according to the present invention is a maintenance method for an exposure apparatus which forms a liquid immersion space by filling a first liquid between an optical member (2) and a substrate (P) and which exposes the substrate with an exposure light via the optical member and the first liquid, the maintenance method comprising: a moving step of arranging a movable member (MST) to be opposite to or face a liquid immersion space-forming member (30) which forms the liquid immersion space with the first liquid; a liquid immersion step of forming the liquid immersion space with the first liquid on the movable member by using the liquid immersion space-forming member; and a cleaning step of jetting a second liquid toward an area including at least a part of a liquid contact portion, which comes into contact with the first liquid, from a side of the movable member to clean the liquid contact portion.

According to the present invention, upon performing the exposure by the liquid immersion method, at least a part of the foreign matter adhered to the liquid contact portion can be easily removed together with the second liquid. In this procedure, by forming the liquid immersion space with the first liquid previously or at least partially concurrently, it is possible to easily remove the foreign matter adhering to the liquid contact portion. Therefore, it is possible to efficiently perform the maintenance for the mechanism which supplies and recovers the first liquid.

A second maintenance method according to the present invention is a maintenance method for an exposure apparatus which forms a liquid immersion space by filling a first liquid between an optical member (2) and a substrate (P) and which exposes the substrate with an exposure light via the optical member and the first liquid, the maintenance method comprising: a moving step of arranging a movable member (MST) to be opposite to a liquid immersion space-forming member (30) which forms the liquid immersion space with the first liquid; an accumulating step of supplying the first liquid onto the movable member by using the liquid immersion space-forming member to accumulate the supplied first liquid; and a cleaning step of jetting the first liquid accumulated in the accumulating step toward an area including at least a part of a liquid contact portion, which comes into contact with the first liquid, to clean the liquid contact portion.
According to the present invention, upon performing the exposure by the liquid immersion method, it is possible to easily remove at least a part of the foreign matter adhered to the liquid contact portion, together with the first liquid. Therefore, it is possible to efficiently perform the maintenance for the mechanism which supplies and recovers the first liquid. In this procedure, by supplying the first liquid, which is used during the liquid immersion exposure, previously or concurrently, it is possible to easily remove the foreign matter adhered to the liquid contact portion. Further, since the first liquid is also used as the cleaning liquid, it is possible to simplify the supply mechanism which supplies the cleaning liquid.

A third maintenance method according to the present invention is a maintenance method for an exposure apparatus which exposes a substrate with an exposure light via an optical member (2) and a first liquid, the maintenance method comprising: arranging a movable member (MST) to be opposite to a nozzle member (30) having a liquid contact portion, which comes into contact with the first liquid, and retaining the first liquid between the optical member and the substrate; and cleaning the liquid contact portion by using a second liquid supplied to the movable member via the nozzle member.
A fourth maintenance method according to the present invention is a maintenance method for an exposure apparatus which exposes a substrate with an exposure light via an optical member (2) and a first liquid, the maintenance method comprising: arranging a movable member to be opposite to a nozzle member which retains the first liquid between the optical member and the substrate; and setting a cleaning condition for cleaning a liquid contact portion, which comes into contact with the first liquid, with a second liquid, depending on information about the liquid contact portion.
According to the inventions as defined above, the liquid contact portion can be cleaned with ease. Consequently, it is possible to efficiently perform the maintenance for the exposure apparatus which performs the exposure by the liquid immersion method.

A first exposure method of the present invention comprises a step of using the maintenance method of the present invention.
A second exposure method of the present invention is an exposure method for exposing a substrate (P) with an exposure light via an optical member (2) and a first liquid, the exposure method comprising: arranging a movable member (MST) to be opposite to a nozzle member (30) having a liquid contact portion, which comes into contact with the first liquid, and retaining the first liquid between the optical member and the substrate; and cleaning the liquid contact portion by using a second liquid supplied to the movable member via the nozzle member.
A third exposure method of the present invention is an exposure method for exposing a substrate (P) with an exposure light via an optical member (2) and a first liquid, the exposure method comprising: arranging a movable member (MST) to be opposite to a nozzle member (30) which retains the first liquid between the optical member and the substrate; and setting a cleaning condition for cleaning a liquid contact portion, which comes into contact with the first liquid, with a second liquid, depending on information about the liquid contact portion.
According to the second and third exposure methods, it is easy to clean the liquid contact portion. Consequently, it is possible to efficiently perform the maintenance for the exposure apparatus which performs the exposure by the liquid immersion method.

A first exposure apparatus according to the present invention is an exposure apparatus which forms a liquid immersion space by filling a first liquid between an optical member (2) and a substrate (P) and which exposes the substrate with an exposure light via the optical member and the first liquid, the exposure apparatus comprising: a liquid immersion space-forming member (30) which forms the liquid immersion space with the first liquid; a movable member (MST) which is movable relative to the optical member; a liquid-jetting mechanism (62, 63A, 90) at least a part of which is provided on the movable member and which jets a second liquid; and a controller (61) which allows the liquid-jetting mechanism to jet the second liquid therefrom toward an area including at least a part of a liquid contact portion, which comes into contact with the first liquid, to clean the liquid contact portion when the liquid immersion space is formed with the first liquid on the movable member via the liquid immersion space-forming member.
A second exposure apparatus according to the present invention is an exposure apparatus which forms a liquid immersion space by filling a first liquid between an optical member (2) and a substrate (P) and which exposes the substrate with an exposure light via the optical member and the first liquid, the exposure apparatus comprising: a liquid immersion space-forming member (30) which forms the liquid immersion space with the first liquid; a movable member (MST) which is movable relative to the optical member; an accumulating mechanism (63F, 91, 92) which accumulates the first liquid supplied onto the movable member via the liquid immersion space-forming member; and a liquid-jetting device (63E, 91, 92) at least a part of which is provided on the movable member and which jets the first liquid accumulated by the accumulating mechanism toward an area including at least a part of a liquid contact portion, which comes into contact with the first liquid, to clean the liquid contact portion.

A third exposure apparatus according to the present invention is an exposure apparatus which exposes a substrate (P) with an exposure light via an optical member (2) and a first liquid, the exposure apparatus comprising: a nozzle member (30) having a liquid contact portion, which comes into contact with the first liquid, and retaining the first liquid between the optical member and the substrate; a movable member (MST) which is movable relative to the optical member; and a cleaning member at least a part of which is provided on the movable member and which cleans the liquid contact portion with a second liquid supplied to the movable member via the nozzle member.
A fourth exposure apparatus according to the present invention is an exposure apparatus which exposes a substrate (P) with an exposure light via an optical member (2) and a first liquid, the exposure apparatus comprising: a nozzle member (30) which retains the first liquid between the optical member and the substrate; a cleaning member which cleans a liquid contact portion, coming into contact with the first liquid, with a second liquid; a movable member (MST) which is arranged to be opposite to the nozzle member at least during the cleaning; and a controller (61) which controls the cleaning member to make a cleaning condition with the second liquid be variable and which sets the cleaning condition depending on information about the liquid contact portion.
The first, second, third, or fourth maintenance method of the present invention can be used by the first, second, third, or fourth exposure apparatus of the present invention.
A method for producing a device according to the present invention comprises exposing a substrate by using the exposure method or the exposure apparatus of the present invention; and developing the exposed substrate.
The parenthesized reference numerals, which are affixed to the predetermined elements of the present invention as defined above, correspond to the members depicted in the drawings to illustrate exemplary embodiments of the present invention. However, the respective reference numerals merely exemplify the elements of the present invention by way of example so that the invention can be understood more easily, and do not limit the present invention to the construction of the embodiment.

### Effect of the Invention:

According to the present invention, it is possible to clean the liquid contact portion with ease. Consequently, it is possible to efficiently perform the maintenance for the exposure apparatus which performs the exposure by the liquid immersion method.

### BRIEF DESCRIPTION OF THE DRAWINGS

Fig. 1 shows a schematic construction, with partial cutout, of an example of an exposure apparatus according to an embodiment of the present invention.
Fig. 2 is a perspective view of a nozzle member 30 shown in Fig. 1.
Fig. 3 is a sectional view taken along a line AA shown in Fig. 2.
Fig. 4 shows, with partial cutout, a cleaning mechanism provided on a side of a measuring stage MST shown in Fig. 1.
Fig. 5 is a plan view of a substrate stage PST and the measuring stage MST shown in Fig. 1.
Fig. 6 is a plan view of a process in which the measuring stage MST is moved to a bottom surface of a projection optical system PL as starting from the state shown in Fig. 5.
Fig. 7 (7(A) to 7(D)) shows, in cross section, a measuring table MTB and a nozzle member 30 to illustrate an example of a cleaning operation of the embodiment of the present invention.
Fig. 8(A) shows, with partial cutout, an example of a cleaning mechanism of another embodiment of the present invention, and Fig. 8(B) shows, with partial cutout, a situation in which the liquid is jetted from the cleaning mechanism.
Fig. 9(A) is a flow chart illustrating an example of a maintenance operation, and Fig. 9(B) is a flow chart illustrating an example of steps of producing a microdevice.

### Legend of reference numerals:

1: liquid, 2: optical element, 10: liquid supply mechanism, 11: liquid supply section, 13, 14: supply port, 20: liquid recovery mechanism, 21: liquid recovery section, 24: recovery port, 25: mesh filter, 30: nozzle member, 62: jetting device, 65: recovery device, 66: mixing jetting device, 89: check valve, 90: jet nozzle portion, 91: cylinder portion, 92: piston portion, AR1: projection area, AR2: liquid immersion area, CONT: controller, EL: exposure light, EX: exposure apparatus, M: mask, P: substrate, PL: projection optical system, PST: substrate stage, MST: measuring stage, MTB: measuring table.

### BEST MODE FOR CARRYING OUT THE INVENTION

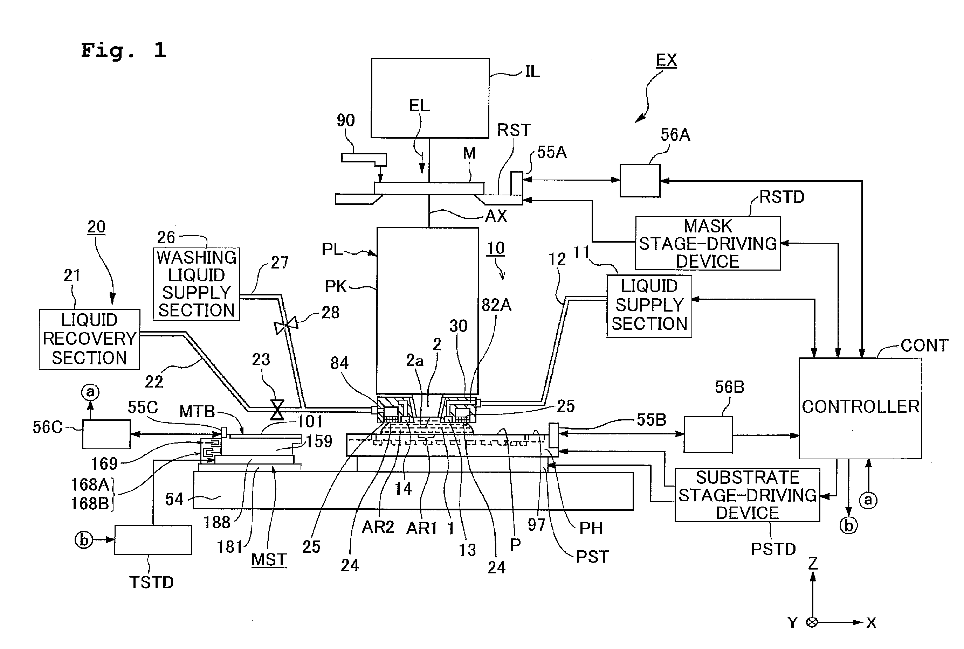

A preferred exemplary embodiment of the present invention will be explained below with reference to Figs. 1 to 7.
Fig. 1 shows a schematic construction of an exposure apparatus EX according to a first embodiment. With reference to Fig. 1, the exposure apparatus EX includes a mask stage RST which supports a mask M formed with a transferring pattern; a substrate stage PST which supports a substrate P as an exposure objective; an illumination optical system IL which illuminates, with an exposure light EL, the mask M supported by the mask stage RST; a projection optical system PL which projects an image of the pattern (pattern image) of the mask M, illuminated with the exposure light EL, onto a projection area AR1 on the substrate P supported by the substrate stage PST; a measuring stage MST which is formed with a reference mark for the alignment, etc.; a controller CONT which integrally controls the operation of the entire exposure apparatus EX; and a liquid immersion system (liquid immersion mechanism) which is provided for the application of the liquid immersion method. The liquid immersion system of this embodiment includes a liquid supply mechanism 10 which supplies the liquid 1 onto the substrate P and onto the measuring stage MST, and a liquid recovery mechanism 20 which recovers the liquid 1 supplied onto the substrate P and onto the measuring stage MST.

The exposure apparatus EX forms the liquid immersion area AR2 (locally) in a partial area on the substrate P including the projection area AR1 of the projection optical system PL or in a part of the area (partial area) on the substrate P and a surrounding area therearound, with the liquid 1 supplied from the liquid supply mechanism 10 at least during a period in which the pattern image of the mask M is transferred onto the substrate P. Specifically, the exposure apparatus EX adopts the local liquid immersion system wherein a space which is between the optical element (for example, a lens having a substantially flat bottom surface (light-exit surface) or a plane-parallel) 2 arranged at the terminal end (end portion) on a side of the image plane (image plane side) of the projection optical system PL and a surface of the substrate P arranged on the image plane side, is filled with the liquid 1; and in which the substrate P is exposed with the exposure light EL allowed to pass through the mask M, via the projection optical system PL and the liquid 1 disposed between the projection optical system PL and the substrate P, so that the pattern of the mask M is transferred to and exposed on the substrate P. In this embodiment, the liquid immersion exposure is performed by using a liquid immersion space-forming member (including, for example, a nozzle member 30) which forms the liquid immersion space including the optical path space for the exposure light EL irradiated from the projection optical system PL.

In this embodiment, an explanation will be made as exemplified by a case using a scanning type exposure apparatus (so-called scanning stepper) as the exposure apparatus EX in which the substrate P is exposed with the pattern formed on the mask M while synchronously moving the mask M and the substrate P in a predetermined or certain scanning direction. The following description will be made assuming that the Z axis extends in parallel to an optical axis AX of the projection optical system PL, the X axis extends in a synchronous movement direction (scanning direction) of the mask M and the substrate P in a plane perpendicular to the Z axis, and the Y axis extends in a direction perpendicular to the scanning direction (non-scanning direction). Directions of rotation (inclination) about the X axis, the Y axis, and the Z axis are designated as the θX, θY, and θZ directions respectively.

In this description, the term "substrate" includes not only a base material itself including a semiconductor wafer such as a silicon wafer, etc. but also those obtained by coating the base material with a resist (photoresist) as a photosensitive material, and also includes those obtained by coating the base material with various films including a protective film (top coat film, etc.) separately from the photosensitive film. The mask includes a reticle on which a device pattern to be subjected to the reduction projection onto the substrate is formed. For example, the mask is obtained such that a predetermined pattern is formed by using a light-shielding film such as chromium on a glass plate (transparent substrate) including, for example, synthetic silica glass, etc. The transmission type mask is not limited to a binary mask in which the pattern is formed with a light-shielding film, and also includes, for example, a phase shift mask of the spatial frequency modulation type, a half tone type, etc. In this embodiment, those usable as the substrate P may be obtained, for example, such that a disc-shaped semiconductor wafer, which has a diameter of about 200 mm to 300 mm, is coated with the photoresist by an unillustrated coater/developer to provide a predetermined thickness (for example, about 200 nm), and the surface thereof is coated with an antireflection film or a top coat film, if necessary.

At first, the illumination optical system IL illuminates, with the exposure light EL, the mask M supported by the mask stage RST. The illumination optical system IL includes an optical integrator which uniformizes the illuminance of the light flux radiated from an unillustrated exposure light source; a condenser lens which collects the exposure light EL from the optical integrator; a relay lens system; a variable field diaphragm which defines the illumination area on the mask M brought about by the exposure light EL to have a slit-shaped form; etc. A predetermined illumination area on the mask M is illuminated with the exposure light EL having the uniform illuminance distribution by the illumination optical system IL. Those used as the exposure light EL irradiated from the illumination optical system IL include emission lines (for example, i-ray) in the ultraviolet region radiated, for example, from a mercury lamp, far ultraviolet light beams (DUV light beams) such as the KrF excimer laser beam (wavelength: 248 nm), and vacuum ultraviolet light beams (VUV light beams) such as the ArF excimer laser beam (wavelength: 193 nm), the F₂ laser beam (wavelength: 157 nm), etc. In this embodiment, the ArF excimer laser beam is used as the exposure light EL.

The mask stage RST supports the mask M. The mask stage RST is two-dimensionally movable in the plane perpendicular to the optical axis AX of the projection optical system PL on an unillustrated mask base, i.e., in the XY plane, and is finely rotatable in the θZ direction. The mask stage RST is driven, for example, by a mask stage-driving device RSTD such as a linear motor. The mask stage-driving device RSTD is controlled by the controller CONT. A movement mirror (reflecting surface) 55A is provided on the mask stage RST. A laser interferometer 56A is provided at a position opposite to or facing the movement mirror 55A. In reality, the laser interferometer 56A constitutes a laser interferometer system having three or more length-measuring axes. The position in the two-dimensional direction and the angle of rotation of the mask stage RST (mask M) are measured in real-time by the laser interferometer 56A. An obtained result of the measurement is outputted to the controller CONT. The controller CONT drives the mask stage-driving device RSTD based on the result of the measurement to thereby move or position the mask M supported by the mask stage RST. The movement mirror 55A is not limited to only the plane mirror, and may include a corner cube (retroreflector). Alternatively, for example, it is also allowable to use a reflecting surface formed by mirror-finishing an end surface (side surface) of the mask stage RST, instead of the movement mirror 55A.

The projection optical system PL projects the pattern of the mask M onto the substrate P to perform the exposure at a predetermined projection magnification β (β represents the reduction magnification, and is, for example, 1/4, 1/5 or the like). The projection optical system PL is constructed by a plurality of optical elements including the optical element 2 which is provided at the terminal end on the side of the substrate P (image plane side of the projection optical system PL). The optical elements are supported by a barrel PK. The projection optical system PL is not limited to the reduction system, and may be any one of the 1x magnification system and the magnifying system. The optical element 2, which is disposed at the end portion of the projection optical system PL, is provided detachably (exchangeably) with respect to the barrel PK. The liquid 1 of the liquid immersion area AR2 comes into contact with the optical element 2. Although not shown, the projection optical system PL is provided on a barrel surface plate supported by three support columns via an anti-vibration mechanism. However, as disclosed, for example, in International Publication No. 2006/038952, the projection optical system PL may be supported in a hanging manner on an unillustrated main frame member which is arranged over or above the projection optical system PL or on the mask base described above, etc.

In this embodiment, pure or purified water is used as the liquid 1. Not only the ArF excimer laser beam but also the far ultraviolet light beam (DUV light beam) such as the KrF excimer laser beam and the emission line radiated, for example, for example, a mercury lamp is also transmissive through pure water. The optical element 2 is formed of calcium fluoride (CaF₂). Calcium fluoride has a high affinity for water. Therefore, it is possible to allow the liquid 1 to make tight contact with the substantially entire surface of a liquid contact surface 2a of the optical element 2. The optical element 2 may be silica glass which has a high affinity for water.

The resist of the substrate P is, as an example, a liquid-repellent resist which repels the liquid 1. As described above, the resist may be coated with the top coat for the protection, if necessary. In this embodiment, the property to repel the liquid 1 is called "liquid repellence". In a case that the liquid 1 is pure or purified water, the liquid repellence means the water repellence.
The substrate stage PST is provided with a substrate holder PH which holds the substrate P, for example, by the vacuum attraction, a Z stage portion which controls the position in the Z direction (focus position) and the angles of inclination in the θX and θY directions of the substrate holder PH (substrate P), and an XY stage portion which is movable while supporting the Z stage portion. The XY stage portion is placed over a guide surface (surface substantially parallel to the image plane of the projection optical system PL) which is parallel to the XY plane on a base 54, for example, with an air bearing (gas bearing) intervening therebetween so that the XY stage portion is movable in the X direction and the Y direction. The substrate stage PST (Z stage portion and XY stage portion) is driven by a substrate stage-driving device PSTD such as a linear motor. The substrate stage-driving device PSTD is controlled by the controller CONT. In this embodiment, the Z stage portion includes a table and an actuator (for example, a voice coil motor, etc.) which drives the table at least in the Z, θX, and θY directions. The substrate holder and the table are formed integrally, and these components are collectively referred to as "substrate holder PH". The substrate stage PST may be a coarse/fine movement stage in which the table is finely movable in the directions of six degrees of freedom with respect to the XY stage portion.

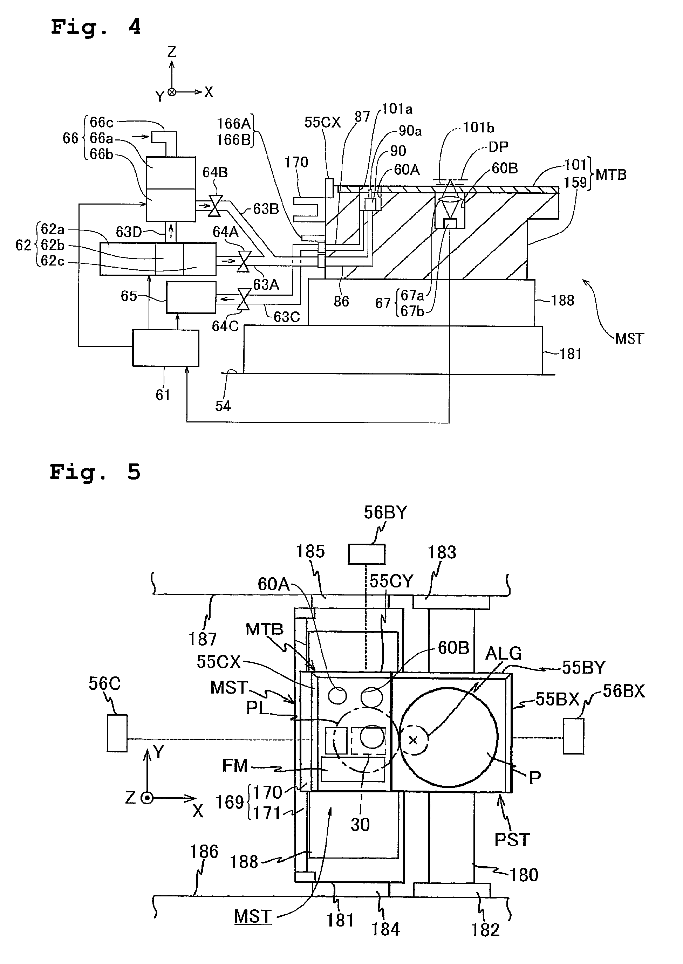

A movement mirror 55B is provided on the substrate holder PH on the substrate stage PST. A laser interferometer 56B is provided at a position opposite to or facing the movement mirror 55B. In reality, as shown in Fig. 5, the movement mirror 55B is constructed of an X axis movement mirror 55BX and a Y axis movement mirror 55BY.
The laser interferometer 56B is also constructed of an X axis laser interferometer 56BX and a Y axis laser interferometer 56BY. With reference to Fig. 1 again, the position in the two-dimensional direction and the angle of rotation of the substrate holder PH (substrate P) on the substrate stage PST are measured in real-time by the laser interferometer 56B; and an obtained result of the measurement is outputted to the controller CONT. The controller CONT drives the substrate stage-driving device PSTD based on the result of the measurement to thereby move or position the substrate P supported by the substrate stage PST. The laser interferometer 56B may be capable of measuring also the information about the position in the Z axis direction and the rotation in the θX and θY directions of the substrate stage PST, and details thereof are disclosed, for example, in Published Japanese Translation of PCT International Publication for Patent Application No. 2001-510577 (corresponding to International Publication No. 1999/28790). A reflecting surface, which is formed, for example, by mirror-finishing a side surface, etc. of the substrate stage PST or the substrate holder PH, may be used instead of the movement mirror 55B.

A plate portion 97, which is annular and flat and which is liquid-repellent, is provided on the substrate holder PH so that the substrate P is surrounded with the plate portion 97. The liquid-repelling process includes, for example, a coating process using a material having the liquid repellence. The material having the liquid repellence includes, for example, fluorine-based resin materials such as polytetrafluoroethylene (Teflon (trade name)), acrylic resin materials, silicon-based resin materials, and synthetic resin materials such as polyethylene. The thin film for the surface process may be a single layer film or a film formed of a plurality of layers. The upper surface of the plate portion 97 is a flat surface which has a height approximately same as that of the surface of the substrate P held by the substrate holder PH. In this case, a gap of about 0.1 to 1 mm is provided between the edge of the substrate P and the plate portion 97. However, in this embodiment, the resist of the substrate P is liquid-repellent, and the liquid 1 has the surface tension. Therefore, the liquid 1 is hardly allowed to inflow into the gap. Even in a case that a portion, which is disposed in the vicinity of the circumferential edge of the substrate P, is exposed, it is possible to retain or hold the liquid 1 between the plate portion 97 and the projection optical system PL. It is also allowable that the substrate holder PH is provided with a sucking device (not shown) in order that the liquid 1, which is allowed to inflow into the gap between the plate portion 97 and the substrate P, is discharged or removed to the outside. Therefore, it is not necessarily indispensable that the resist (or the top coat) of the substrate P is liquid-repellent. In this embodiment, the plate portion 97 is provided detachably (exchangeably) for the substrate holder PH. However, the upper surface of the substrate holder PH, which surrounds the substrate P, may be subjected to the liquid-repelling process to form the flat surface, without providing the plate portion 97. In this case, it is preferable that the substrate holder PH is detachable (exchangeable) and that the maintenance (for example, the repair of the liquid-repellent film) is performed for the flat surface.

### Description of Liquid Supply and Recovery Mechanisms

Next, the liquid supply mechanism 10 shown in Fig. 1 is provided to supply the predetermined liquid 1 onto the substrate P. The liquid supply mechanism 10 includes a liquid supply section 11 which is capable of feeding the liquid 1, and a supply tube 12 which has one end connected to the liquid supply section 11. The liquid supply section 11 is provided with a tank which accommodates the liquid 1, a filter section, a pressurizing pump, etc. It is not necessarily indispensable that the liquid supply mechanism 10 is provided with all of the tank, the filter section, the pressurizing pump, etc.; and at least a part or parts thereof may be substituted, for example, with an equipment of the factory or the like in which the exposure apparatus EX is installed.

The liquid recovery mechanism 20 is provided to recover the liquid 1 supplied onto the substrate P. The liquid recovery mechanism 20 includes a liquid recovery section 21 which is capable of recovering the liquid 1, a recovery tube 22 which has one end connected to the liquid recovery section 21, a supply tube 27 which is connected to the recovery tube 22, and a cleaning liquid supply section 26 which is connected to the end of the supply tube 27 to supply a predetermined cleaning liquid. Valves 23, 28 are provided at intermediate positions of the recovery tube 22 and the supply tube 27 respectively. The liquid recovery section 21 is provided with, for example, a vacuum system (sucking device) such as a vacuum pump, and a tank which accommodates the recovered liquid 1. The cleaning liquid supply section 26 is provided with a tank which accommodates the cleaning liquid, a pressurizing pump, etc. By closing the valve 23 disposed on the side of the recovery tube 22 and by opening the valve 28 disposed on the side of the supply tube 27, it is possible to supply the cleaning liquid from the cleaning liquid supply section 26 via the supply tube 27 to the recovery tube 22. It is not necessarily indispensable that the liquid recovery mechanism 20 is provided with all of the vacuum system, the tank, etc.; and at least a part or parts thereof may be substituted, for example, with an equipment of the factory or the like in which the exposure apparatus EX is installed.

Those usable as the cleaning liquid include a mixture liquid of thinner and water as the liquid distinct from the liquid 1, γ-butyrolactone, a solvent such as isopropyl alcohol (IPA), etc. However, it is also possible to use, as the cleaning liquid, a liquid containing the liquid 1, for example, the liquid 1 itself; the liquid 1 dissolved with a gas (for example, nitrogen, ozone, or oxygen); a solution containing the liquid 1 as the solvent; etc. In a case that the liquid 1 itself is used as the cleaning liquid, then the liquid supply section 11 can be also used as the cleaning liquid supply section.
Therefore, it is not necessarily indispensable to provide the cleaning liquid supply section 26 and the supply tube 27. The supply tube 27 extending from the cleaning liquid supply section 26 can be also connected to the supply tube 12 which is communicated with the liquid supply section 11. In this case, the cleaning liquid may be supplied to the liquid immersion area (liquid immersion space) independently from the supply flow passage of the liquid 1 (for example, the supply tube 12).

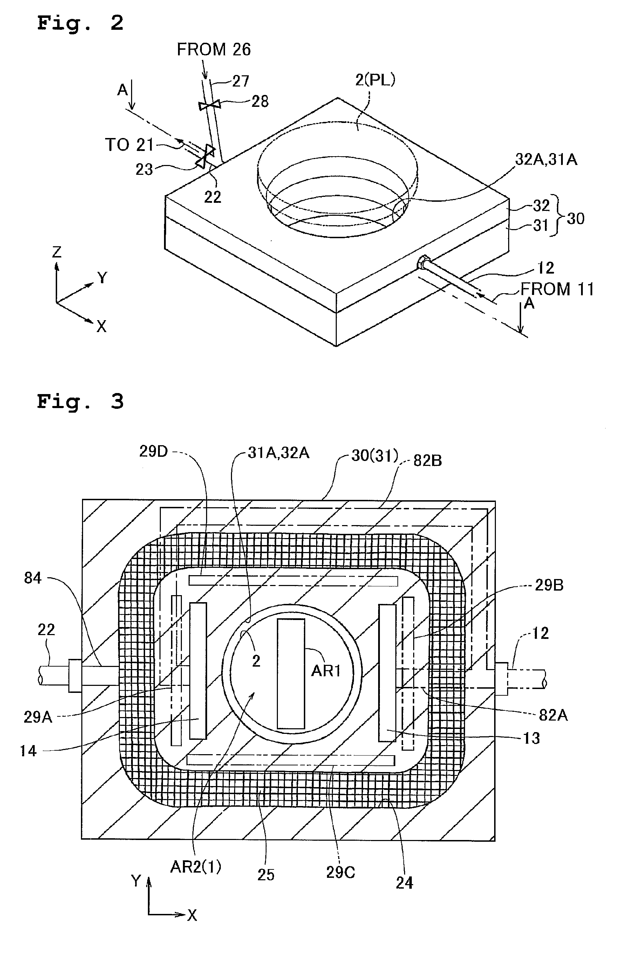

The nozzle member 30 is arranged as a flow passage-forming member in the vicinity of the optical element 2 disposed at the terminal end of the projection optical system PL. The nozzle member 30 is an annular member which is provided to surround the circumference of the optical element 2 at a position over or above the substrate P (substrate stage PST). The nozzle member 30 is supported by a column mechanism (not shown) via an unillustrated support member. The nozzle member 30 is provided with a first supply port 13 and a second supply port 14 (see Fig. 3) which are arranged to be opposite to or to face the surface of the substrate P in a state that the projection area AR1 of the projection optical system PL is located on the substrate P. The nozzle member 30 has supply flow passages 82A, 82B (see Fig. 3) disposed at the inside thereof. One end of the supply flow passage 82A is connected to the first supply port 13, and the second supply port 14 is connected via the supply flow passage 82B to an intermediate portion of the supply flow passage 82A (see Fig. 3). The other end of the supply flow passage 82A is connected to the liquid supply section 11 via the supply tube 12. Further, the nozzle member 30 is provided with a recovery port 24 (see Fig. 3) which has a rectangular frame-shaped form and which is arranged to be opposite to or face the surface of the substrate P.

Fig. 2 is a perspective view schematically illustrating the nozzle member 30. As shown in Fig. 2, the nozzle member 30 is the annular member which is provided to surround the circumference of the optical element 2 disposed at the terminal end of the projection optical system PL. As an example, the nozzle member 30 is provided with a first member 31, and a second member 32 which is arranged on the upper portion of the first member 31. The first and second members 31, 32 are plate-shaped members respectively, and have through-holes 31A, 32A, respectively, which are disposed at central portions thereof and in which the projection optical system PL (optical element 2) can be arranged.

Fig. 3 shows a sectional view taken along a line AA illustrating the first member 31 disposed at the lower stage of the nozzle member 30 shown in Fig. 2. In Fig. 3, the supply flow passages 82A, 82B formed in the second member 32 disposed on the first member 31 and the supply tube 12 connected to the supply flow passage 82A are depicted by two-dot chain lines. The first member 31 of the nozzle member 30 is provided with the first supply port 13 which is formed on the side in the +X direction of the optical element 2 of the projection optical system PL and which supplies the liquid 1 onto the substrate P, and the second supply port 14 which is formed on the side in the -X direction of the optical element 2 and which supplies the liquid 1 onto the substrate P. The supply ports 13, 14 are arranged to interpose the projection area AR1 in the X direction (scanning direction of the substrate P). Each of the supply ports 13, 14 is a through-hole which penetrates through the first member 31 and which has a rectangular shape that is long in the Y direction. However, it is also allowable to adopt a circular arc-shaped form which is spread outwardly from the center of the projection area AR1, etc.

Further, the first member 31 has a frame-shaped recovery port 24 which is formed in the first member 31, which is rectangular (or may be circular, etc.) and which is arranged to surround the optical element 2 of the projection optical system PL (projection area AR1); and a recovery flow passage 84 which is formed in the first member 31 and which makes communication between the recovery port 24 and the recovery tube 22. The recovery port 24 is a groove-shaped recess formed on the bottom surface of the first member 31, and the recovery port 24 is provided on the outer side of the supply ports 13, 14 with respect to the optical element 2. A gap between the substrate P and the supply ports 13, 14 and a gap between the substrate P and the recovery port 24 are provided substantially identically. However, for example, the gap between the substrate P and the recovery port 24 may be made narrower than the gap between the substrate P and the supply ports 13, 14. The nozzle member 30 is provided with a porous member 25. The porous member 25 is provided, for example, at the flow passage or the passage port for the liquid 1 of the first member 32 (including at least one of the supply ports 12, 14 and the recovery port 24). In this embodiment, a mesh filter, which has a large number of small holes formed in a mesh form, is fitted as the porous member 25 to cover the recovery port 24. In the following description, the porous member 25 is also referred to as "mesh filter". The porous member 25 is not limited to the mesh filter. The porous member 25 may be formed of, for example, a material having pores including sintered metal, ceramics, etc. The liquid immersion area AR2, which is filled with the liquid 1, is formed inside an area which is substantially rectangular (or may be circular, etc.) and which is surrounded by the recovery port 24 to include the projection area AR1. Further, the liquid immersion area AR2 is formed locally on a part of the surface of the substrate P (or in a form to include a part of the surface of the substrate P) during the scanning exposure. The nozzle member (flow passage-forming member) 30 fills the space between the optical element 2 and the substrate P with the liquid 1 to form the local liquid immersion space (corresponding to the liquid immersion area AR2) including the optical path space for the exposure light EL. Therefore, the nozzle member (flow passage-forming member) 30 is referred to as "liquid immersion space-forming member", "containment member" (or "confinement member"), etc. as well.

Each of the first member 31 and the second member 32 of the nozzle member 30 shown in Fig. 2 and the mesh filter 25 shown in Fig. 3 is formed of a liquid-attractive material which has relatively high affinity for the liquid 1, for example, stainless steel (SUS) or titanium. Therefore, with reference to Fig. 1, the liquid 1 in the liquid immersion area AR2 is allowed to pass through the mesh filter 25 of the recovery port 24 provided on the nozzle member 30, and then the liquid 1 is smoothly recovered by the liquid recovery section 21 via the recovery flow passage 84 and the recovery tube 22. In this process, a foreign matter, which is included in the foreign matter such as the resist residue or the like and which is larger than the meshes of the mesh filter 25, remains on the surface of the mesh filter 25.

With reference to Fig. 3, the liquid recovery port 24 of this embodiment has the rectangular or circular frame-shaped form. However, instead of this construction, as depicted by two-dot chain lines, the following construction is also available. That is, it is allowable that the recovery port is constructed by using two recovery ports 29A, 29B which are rectangular (or may be circular arc-shaped, etc.) and which are arranged to interpose the supply ports 13, 14 in the X direction and two recovery ports 29C, 29D which are rectangular (or may be circular arc-shaped, etc.) and which are arranged to interpose the optical element 2 in the Y direction; so that the mesh filter is arranged on each of the recovery ports 29A to 29D. The number of the recovery ports 29A to 29D is arbitrary. For example, as disclosed in International Publication No. 2005/122218, the recovery ports 29A to 29D and the recovery port 24 may be used in a duplicate manner to recover the liquid 1 in the liquid immersion area AR2. Further, the mesh filters may be also arranged on the recovery ports 13, 14 in order to prevent any foreign matter in the liquid immersion area AR2 from entering into and contaminating the inside of the nozzle member 30. On the contrary, for example, in a case that the possibility of the adhesion of the foreign matter to the inside of the recovery tube 22 is low, it is not necessarily indispensable to provide the mesh filter 25.

The nozzle member 30 used in the embodiment described above is not limited to the structure described above. For example, it is also possible to use flow passage-forming members or the like described, for example, in European Patent Application Publication No. 1420298, International Publication Nos. 2004/055803, 2004/057589, and 2004/057590, and International Publication No. 2005/029559 (corresponding to United States Patent Application Publication No. 2006/0231206).

In this embodiment, the liquid supply ports 13, 14 and the recovery port 24 are provided on the same nozzle member 30. However, the supply ports 13, 14 and the recovery port 24 may be provided on distinct members. For example, only the supply port may be provided on another member different from the nozzle member 30. Alternatively, only the recovery port may be provided on the another member. In a case that a second recovery port is provided at the outside of the recovery port 24, the second recovery port may be provided on the another member. Further, with reference to Fig. 1, the supply ports 13, 14 may be communicated with different and distinct liquid supply sections, and the liquid 1 may be supplied from the supply ports 13, 14 to the liquid immersion area AR2 in a state that the supply amounts can be controlled independently from each other.

It is also allowable that the liquid supply ports 13, 14 are not arranged to be opposite to the substrate P. Further, the nozzle member 30 of this embodiment has the lower surface which is set to be arranged nearer to the image plane side (substrate side) than the lower end surface of the projection optical system PL. However, the lower surface of the nozzle member 30 may be defined at a height (Z position) approximately same as that of the lower end surface (light-exit surface) of the projection optical system PL. A part (lower end portion) of the nozzle member 30 may be provided to extend crawlingly until arrival at a position under the projection optical system PL (optical element 2) so that the exposure light EL is not shielded or blocked.

As described above, the nozzle member 30 forms a part of the liquid supply mechanism 10 and a part of the liquid recovery mechanism 20 respectively. That is, the nozzle member 30 is a part of the liquid immersion system. On the other hand, the valves 23, 28, which are provided for the recovery tube 22 and the supply tube 27, open/close the flow passages of the recovery tube 22 and the supply tube 27 respectively, and the operations of the valves 23, 28 are controlled by the controller CONT. The liquid recovery section 21 is capable of sucking and recovering the liquid 1 from the liquid immersion area AR2 via the recovery port 24 during a period in which the flow passage of the recovery tube 22 is open. When the flow passage of the recovery tube 22 is closed by the valve 23 in a state that the valve 28 is closed, the sucking recovery of the liquid 1 via the recovery port 24 is stopped. Afterwards, by opening the valve 28, it is possible to allow the cleaning liquid to flow through the recovery port 24 of the nozzle member 30 from the cleaning liquid supply section 26 via the supply tube 27, the recovery tube 22, and the mesh filter 25.

A part or parts of the liquid immersion system, for example, at least the nozzle member 30, is/are provided on the above-described column mechanism (not shown) on which the body of the exposure apparatus EX (apparatus body) is provided, i.e., on the main frame holding the projection optical system PL (including the barrel surface plate described above, etc.). However, there is no limitation to this. The part or parts of the liquid immersion system, for example, at least the nozzle member 30 may be provided, for example, on a frame member different from the column mechanism (main frame). Alternatively, in a case that the projection optical system PL is supported in the hanging manner as described above, the nozzle member 30 may be supported in a hanging manner integrally with the projection optical system PL. Alternatively, the nozzle member 30 may be provided on a measuring frame supported in a hanging manner independently from the projection optical system PL. In the case of the latter, it is also allowable that the projection optical system PL is not supported in the hanging manner.

With reference to Fig. 1, the liquid supply operations of the liquid supply section 11 and the cleaning liquid supply section 26 are controlled by the controller CONT. The controller CONT is capable of independently controlling the liquid supply amounts per unit time to be supplied onto the substrate P by the liquid supply section 11 and the cleaning liquid supply section 26 respectively. The liquid 1, which is fed from the liquid supply section 11, is supplied onto the substrate P from the supply ports 13, 14 (see Fig. 3) provided on the lower surface of the nozzle member 30 to be opposite to the substrate P, via the supply tube 12 and the supply flow passages 82A, 82B of the nozzle member 30.

The liquid recovery operation of the liquid recovery section 21 is controlled by the controller CONT. The controller CONT is capable of controlling the liquid recovery amount per unit time to be recovered by the liquid recovery section 21. The liquid 1 on the substrate P, which is recovered via the mesh filter 25 from the recovery port 24 provided over or above the substrate P, is recovered by the liquid recovery section 21 via the recovery tube 22 and the recovery flow passage 84 of the nozzle member 30.

### Description of Measuring Stage

With reference to Fig. 1, the measuring stage MST includes an X stage portion 181 which has an oblong shape long in the Y direction and which is driven in the X direction (scanning direction); a leveling table 188 which is placed on the X stage portion 181, for example, with an air bearing intervening therebetween; and a measuring table MTB which serves as a measuring unit arranged on the leveling table 188. As an example, the measuring table MTB is placed on the leveling table 188 with an air bearing intervening therebetween. However, the measuring table MTB and the leveling table 188 can be integrated into one body as well. The X stage portion 181 is placed movably in the X direction on the base 54, for example, with an air bearing intervening therebetween.

Fig. 5 is a plan view of the substrate stage PST and the measuring stage MST shown in Fig. 1. With reference to Fig. 5, X axis stators 186, 187, each of which includes a plurality of permanent magnets arranged in a predetermined arrangement in the X direction on the inner surface, are installed in parallel to the X axis to interpose the base 54 in the Y direction (non-scanning direction) between the X axis stators 168, 187. A Y axis slider 180 is arranged movably in the X direction substantially in parallel to the Y axis between the stators 186, 187 via movers 182, 183 which include coils respectively. The substrate stage PST is arranged movably in the Y direction along the Y axis slider 180. A Y axis linear motor, which drives the substrate stage PST in the Y direction, is constructed by movers in the substrate stage PST and stators (not shown) on the Y axis slider 180. A pair of X axis linear motors, which drive the substrate stage PST in the X direction, are constructed by the movers 182, 183 and the stators 186, 187 corresponding thereto respectively. The X axis and Y axis linear motors, etc. constitute the substrate stage-driving device PSTD shown in Fig. 1.

On the other hand, an X stage portion 181 of the measuring stage MST is arranged movably in the X direction between stators 186, 187 via movers 184, 185 including coils respectively. A pair of X axis linear motors, which drive the measuring stage MST in the X direction, are constructed by the movers 184, 185 and the stators 186, 187 corresponding thereto respectively. The X axis linear motors, etc. are represented by the measuring stage-driving device TSTD in Fig. 1.

With reference to Fig. 5, a stator 167 which has a "]"-shaped cross-sectional form and in which a plurality of permanent magnets are arranged to generate the uniform magnetic field in the Z direction, to be opposite to or face the inner surface and a stator 171 which has a flat plate-shaped form and which includes a coil wound (arranged) substantially along the X axis are successively fixed to an end of the X stage 181 in the -X direction so that the stators 167, 171 are disposed substantially in parallel to the Y axis and are stacked in the Z direction. Movers 166A, 166B, which include coils wound (arranged) along the Y axis, are fixed at two positions respectively, the two positions being separated in the Y direction on the measuring table MTB so that the movers 166A, 166B are arranged in the stator 167 disposed at the lower position. A mover 170, which has a "]"-shaped cross-sectional form and in which a plurality of permanent magnets are arranged in a predetermined arrangement in the Y direction, is fixed to the measuring table MTB so that the stator 171 disposed at the upper position is interposed in the Z direction. X axis voice coil motors 168A, 168B (see Fig. 1), which drive the measuring table MTB in the X direction and the θZ direction in minute amounts with respect to the X stage portion 181 respectively, are constructed by the movers 166A, 166B and the stator 167 disposed at the lower position. A Y axis linear motor 169, which drives the measuring table MTB in the Y direction with respect to the X stage portion 181, is constructed by the mover 170 and the stator 171 disposed at the upper position.

An X axis movement mirror (reflecting surface) 55CX and a Y axis movement mirror (reflecting surface) 55CY are fixed in the -X direction and the +Y direction on the measuring table MTB respectively. An X axis laser interferometer 56C is arranged to be opposite to or face the movement mirror 55CX in the -X direction. The movement mirrors 55CX, 55CY are represented by the movement mirror 55C in Fig. 1. The laser interferometer 56C is a multi-axis laser interferometer. The position in the X direction and the angle of rotation in the θZ direction, etc. of the measuring table MTB are always measured by the laser interferometer 56C. For example, a reflecting surface, which is formed by mirror-finishing a side surface, etc. of the measuring stage MST, may be used instead of the movement mirrors 55CX, 55CY.

On the other hand, with reference to Fig. 5, the laser interferometer 56BY, which is provided to measure the position in the Y direction, is commonly used for the substrate stage PST and the measuring stage MST. That is, the optical axes of the two X axis laser interferometers 56BX, 56C pass through the center of the projection area AR1 of the projection optical system PL (coincident with the optical axis AX shown in Fig. 1 in this embodiment), and the optical axes are parallel to the X axis. The optical axis of the Y axis laser interferometer 56BY passes through the center of the projection area (optical axis AX), and the optical axis is parallel to the Y axis. Therefore, usually, when the substrate stage PST is moved to the position under or below the projection optical system PL in order to perform the scanning exposure, then the laser beam of the laser interferometer 56BY is irradiated onto the movement mirror 55BY of the substrate stage PST, and the position of the substrate stage PST (substrate P) in the Y direction is measured by the laser interferometer 56BY. When the measuring table MTB of the measuring stage MST is moved to the position under or below the projection optical system PL in order to measure, for example, the image formation characteristic of the projection optical system PL, etc., then the laser beam of the laser interferometer 56BY is irradiated onto the movement mirror 55CY of the measuring table MTB, and the position of the measuring table MTB in the Y direction is measured by the laser interferometer 56BY. Accordingly, the positions of the substrate stage PST and the measuring table MTB can be always measured highly accurately, with the center of the projection area of the projection optical system PL as a reference. Further, it is possible to decrease the number of laser interferometers which are highly accurate but expensive, thereby making it possible to reduce the production cost.

Linear encoders (not shown) of the optical system, etc. are arranged along the Y axis linear motor for the substrate stage PST and the Y axis linear motor 169 for the measuring table MTB. The position in the Y direction of the substrate stage PST or the measuring table MTB is measured by each of the linear encoders during a period in which the laser beam of the laser interferometer 56BY is not irradiated onto the movement mirror 55BY or 55CY.

With reference to Fig. 1 again, the position in the two-dimensional direction and the angle of rotation of the measuring table MTB are measured by the laser interferometer 56C and the laser interferometer 56BY shown in Fig. 5 (or the linear encoder). An obtained result of the measurement is outputted to the controller CONT. The controller CONT drives the measuring stage-driving device TSTD, the linear motor 169, and the voice coil motors 168A, 168B based on the measurement result to thereby move or position the measuring table MTB of the measuring stage MST.

The leveling table 188 is provided with three Z axis actuators each of which is capable of controlling the position in the Z direction, for example, in accordance with an air cylinder or voice coil motor system respectively. Usually, the position in the Z direction and the angles in the θX direction and the θY direction of the measuring table MTB are controlled by the leveling table 188 so that the upper surface of the measuring table MTB is focused with respect to the image plane of the projection optical system PL. For this purpose, an autofocus sensor (not shown) is provided in the vicinity of the nozzle member 30 in order to measure the position of a detection objective surface such as the upper surface of the substrate P disposed in the projection area AR1 and in the vicinity of the projection area AR1. The controller CONT controls the operation of the leveling table 188 based on the measured value obtained by the autofocus sensor. Further, although not shown, an actuator is also provided in order that the position of the leveling table 188 in the X direction, the Y direction, and the θZ direction with respect to the X stage portion 181 is maintained at a predetermined position.

The autofocus sensor also detects the information about the inclination in the θX and θY directions (angle of rotation) by measuring the position information in the Z direction about the detection objective surface at a plurality of measuring points thereof respectively. At least a part or parts of the plurality of measuring points may be defined in the liquid immersion area AR2 (or in the projection area AR1). Alternatively, all of the plurality of measuring points may be defined outside the liquid immersion area AR2. Further, for example, when the laser interferometers 56B, 56C are capable of measuring the position information in the Z axis, θX, and θY directions about the detection objective surface, then it is also allowable that the autofocus sensor is not provided for the purpose of making it possible to measure the position information in the Z direction during the exposure operation of the substrate P. It is also allowable that the position of the detection objective surface is controlled in relation to the Z axis, θX, and θY directions by using the measurement results of the laser interferometers 56B, 55C at least during the exposure operation.

The measuring table MTB of this embodiment is provided with measuring devices (measuring members) for performing various types of measurement in relation to the exposure. That is, the measuring table MTB is provided with a body 159 of the measuring table (measuring-table body 159) to which the movement mirror 55C, the mover of the linear motor 169, etc. are fixed; and a plate 101 which is fixed to the upper surface of the measuring-table body 159 and which is formed of a light-transmissive material having a low coefficient of expansion including, for example, silica glass, etc. A chromium film is formed on the substantially entire surface of the plate 101; and the plate 101 has, at a several positions of the plate 101, an area for the measuring device and a reference mark area FM having a plurality of reference marks formed therein, as disclosed in Japanese Patent Application Laid-open No. 5-21314 (corresponding to United States Patent No. 5,243,195), etc.

As shown in Fig. 5, a pair of reference marks FM1, FM2 for an alignment sensor AS for the mask shown in Fig. 1 and a reference mark FM3 for an alignment sensor ALG for the substrate arranged on a side surface of the projection optical system PL are formed in the reference mark area FM on the plate 101. By measuring the positions of the reference marks with the alignment sensors corresponding to the reference marks, respectively, it is possible to measure the baseline amount as the spacing distance (positional relationship) between the projection position of the projection area AR1 of the projection optical system PL and the detecting position of the alignment sensor ALG. Upon measuring the baseline amount, the liquid immersion area AR2 is formed also on the plate 101. Each of the alignment sensors AS, ALG may be of the image processing system. Alternatively, each of the alignment sensors AS, ALG may be, for example, of a system in which a diffracted light generated from the mark by being irradiated with a coherent beam is detected.

Various types of measuring aperture patterns are formed in the area for the measuring devices on the plate 101. The measuring aperture patterns include, for example, an aperture pattern for measuring the spatial image (for example, a slit-shaped aperture pattern), a pinhole aperture pattern for measuring the uneven illuminance, an aperture pattern for measuring the illuminance, and an aperture pattern for measuring the wave aberration. Measuring devices, which correspond to the aperture patterns respectively and each of which is constructed of a measuring optical system and a photoelectric sensor, are arranged in the measuring-table body 159 disposed on the bottom surface side of the aperture patterns.

Examples of the measuring devices include an uneven illuminance sensor as disclosed, for example, in Japanese Patent Application Laid-open No. 57-117238 (corresponding to United States Patent No. 4,465,368); a spatial image-measuring device for measuring the light intensity of the spatial image (projected image) of the pattern projected by the projection optical system PL as disclosed, for example, in Japanese Patent Application Laid-open No. 2002-14005 (corresponding to United States Patent Publication No. 2002/0041377); an illuminance monitor as disclosed, for example, in Japanese Patent Application Laid-open No. 11-16816 (corresponding to United States Patent Publication No. 2002/0061469); a wave aberration-measuring device as disclosed, for example, in International Publication No. 99/60361 (corresponding to European Patent No. 1,079,223); etc.

In this embodiment, corresponding to that the liquid immersion exposure is performed to expose the substrate P with the exposure light EL via the projection optical system PL and the liquid 1, the exposure light EL is received via the projection optical system PL and the liquid 1 in the uneven illuminance sensor, the illuminance monitor, the spatial image-measuring device, the wave aberration-measuring device described above, etc. to be used for the measurement using the exposure light EL. Therefore, a liquid-repellent coat is applied to a surface of the plate 101.

### Description of Mechanism for Jetting Cleaning Liquid

Fig. 4 shows a jetting mechanism for jetting the cleaning liquid, the jetting mechanism being installed to the measuring stage MST. With reference to Fig. 4 in which the measuring table MTB is shown in cross section, recesses 60A, 60B are formed at two positions on the upper surface of the measuring-table body 159. An aperture 101a is formed through the plate 101 at a portion above the first recess 60A. Neither light-shielding film nor liquid-repellent coat is formed in an area 101b of the plate 101 above the second recess 60B Therefore, the illumination light can pass through the plate 101 at the area 101b.

A jet nozzle portion 90 provided to jet the cleaning liquid, which is supplied from the bottom portion, from a jetting port 90a in the upward direction at a high velocity is fixed to a central portion of the first recess 60A. A liquid inflow port, which is provided at the bottom portion of the jet nozzle portion 90, is connected to a cleaning liquid-jetting device 62 via a supply flow passage 86 which is disposed in the measuring-table body 159 and a flexible piping 63A which is disposed at the outside of the measuring-table body 159. That is, in this embodiment, the cleaning mechanism is provided with the jetting mechanism shown in Fig. 4, wherein the liquid contact portion, which comes into contact with the liquid 1, is cleaned by the jetting of the cleaning liquid. In this embodiment, the cleaning liquid is jetted at a high pressure to perform the high pressure cleaning as an aspect of jetting the cleaning liquid. It is also appropriate to clean all of the liquid contact portion which comes into contact with the liquid 1 at least during the liquid immersion exposure. However, in this embodiment, only a part of the liquid contact portion, for example, a part of the lower surface of the nozzle member 30 is cleaned. As another aspect of jetting the cleaning liquid, it is also allowable to spray the cleaning liquid in a form of mist. A plurality of pieces of the jet nozzle portion 90 may be provided, and the jet nozzle portions 90 may be arranged, for example, in one array or row. It is also possible to set the jetting direction, in which the cleaning liquid is jetted from the jetting port 90a of the jet nozzle portion 90, for example, as an oblique direction other than a direction perpendicular to the upper surface of the plate 101. That is, the jetting angle of the cleaning liquid with respect to the upper surface of the plate 101 is not limited to 90 degrees. The jetting angle of the cleaning liquid may be varied, for example, by driving the jet nozzle portion 90 by an actuator. The cleaning liquid may be jetted from the jetting port 90a while being spread within a predetermined angle range. Further, it is also allowable to change the cleaning condition for cleaning the liquid contact portion by the jetting mechanism, including, for example, the type (including, for example, the mixing ratio and the concentration of the dissolved gas described above), the pressure, the jetting pattern, and the temperature of the cleaning liquid to be jetted from the jet nozzle portion 90, depending on the information about the liquid contact portion including, for example, the cleaning portion and/or the degree of dirt. In this case, the number of the cleaning condition or conditions to be changed is not limited to one, and may be a plural. The cleaning condition is not limited to at least one of the characteristic of the cleaning liquid and the jetting condition. It is not necessarily indispensable that the cleaning mechanism is provided with the jetting mechanism.

The jetting device 62 includes an accumulating section 62a for the cleaning liquid, a temperature adjusting section 62b which adjusts the temperature of the cleaning liquid supplied from the accumulating section 62a at a predetermined temperature (for example, a high temperature), and a pressurizing section 62c which feeds the temperature-adjusted cleaning liquid toward the piping 63A at a high pressure. The operations of the accumulating section 62a, the temperature adjusting section 62b, and the pressurizing section 62c are controlled by a controller 61 including a computer. For example, in a case that the cleaning objective portion is dirtied to a great extent, the temperature of the cleaning liquid may be raised. Further, a mixing jetting device 66, which mixes and jets a gas and the cleaning liquid, is connected to an intermediate portion of the piping 63A via a flexible piping 63B. The mixing jetting device 66 includes, for example, a gas-sucking section 66a which inhales or sucks the air in the clean room via a duct 66c and an internal dust-removing filter, and a mixing pressuring section 66b. The mixing pressurizing section 66b mixes the gas supplied from the gas-sucking section 66a and the temperature-adjusted cleaning liquid supplied via a piping 63D from the temperature adjusting section 62b of the jetting device 62 so that the mixed gas and cleaning liquid are fed at a predetermined pressure toward the piping 63B. The operations of the gas-sucking section 66a and the mixing pressurizing section 66b are controlled by the controller 61.

Valves 64A, 64B are installed to the pipings 63A, 63B respectively. Upon using the jetting device 62, the controller 61 closes the valve 64B and opens the valve 64A. Upon using the mixing jetting device 66, the controller 61 closes the valve 64A and opens the valve 64B. It is desirable that the valves 64A, 64B (as well as a valve 64C described later on) are provided at positions as close as possible to the measuring table MTB in consideration of the fear of leakage of the internal liquid due to the frequent bending of the pipings 63A, 63B caused by the movement of the measuring stage MST.

The bottom surface of the recess 60A is connected to a liquid recovery device 65 via a recovery flow passage 87 disposed in the measuring-table body 159 and a flexible piping 63C disposed at the outside of the measuring-table body 159. An opening/closing valve 64C is installed to the piping 63C as well. The recovery device 65 includes a sucking pump, a dust-removing filter section, and an accumulating section for the recovered liquid; and the operation thereof and the opening/closing operation of the valve 64C are controlled by the controller 61. In this embodiment, the cleaning liquid or the like (including the liquid forming the liquid immersion area AR2), which enters the recess 60A, is recovered by the recovery device 65. The cleaning liquid or the like, which enters the recess 60A, can be also sucked and recovered via the nozzle member 30 by the liquid recovery section 21 shown in Fig. 1. In this case, it is also possible to omit the recovery mechanism for the cleaning liquid or the like which is disposed on the side of the measuring stage MST and which includes the recovery device 65, the piping 63C, and the recovery flow passage 87.

An observing device 67, which includes an objective lens 67a, a two-dimensional image pickup device 67b such as CCD, and an unillustrated illumination system which illuminates a detection objective surface DP, is arranged in the second recess 60B on the measuring-table body 159 shown in Fig. 4. The image pickup signal, which is obtained by the image pickup device 67b, is supplied via the controller 61 to an image processing system of the controller CONT shown in Fig. 1. Based on the image pickup signal (image of the detection objective surface DP), the image processing system performs, for example, the confirmation of the degree of dirt and the confirmation of the position of the member as the cleaning objective to be cleaned by the jet nozzle portion 90. In this embodiment, the positional relationship between the reference marks FM1 to FM3 and the recess 60A is known in Fig. 5. Further, by detecting the reference marks FM1 to FM3 with the alignment sensor ALG, it is possible to measure the positional relationship with respect to the nozzle member 30 shown in Fig. 1. Therefore, the positional relationship between the jet nozzle portion 90 shown in Fig. 4 and the nozzle member 30 (cleaning objective) shown in Fig. 1 can be also determined highly accurately from the measurement result. Therefore, it is not necessarily indispensable to provide the observing device 67. In a case that the observing device 67 is provided for the measuring stage MST, a part of the observing device 67, for example, the illumination system described above may be arranged outside the measuring stage MST.

Those usable as the cleaning liquid to be jetted from the jetting device 62 shown in Fig. 4 include, for example, a mixture liquid of thinner and water, γ-butyrolactone, a solvent such as IPA, and the liquid containing the liquid 1 described above, in the same manner as the cleaning liquid which is supplied from the cleaning liquid supply section 26 shown in Fig. 1. In this embodiment, it is assumed that the cleaning liquid, which is jetted from the jetting device 62, is of the same type as that of the cleaning liquid which is supplied from the cleaning liquid supply section 26. The control of the operations of the jetting device 62, the mixing jetting device 66, and the recovery device 65 performed by the controller 61, the opening/closing operations of the valves 64A to 64C, and the operation of the measuring stage MST corresponding to these operations are integrally controlled by the controller CONT shown in Fig. 1. The accumulating section 62a, for the cleaning liquid, of the jetting device 62 may be a detachable vessel or container of the cassette system. The liquid, which is recovered by the recovery device 65 (or the liquid recovery section 21 shown in Fig. 1), may be returned to the vessel of the cassette system via a dust-removing filter; and the recovered liquid may be reused as the cleaning liquid. The type of the cleaning liquid for the jetting device 62 may be different from the type of the cleaning liquid for the cleaning liquid supply section 26. For example, a solvent such as IPA may be supplied by the cleaning liquid supply section 26, and the jetting device 62 may jet the liquid 1 itself. Further, a part or parts of the cleaning mechanism may be substituted, for example, with an equipment of the factory or the like in which the exposure apparatus EX is installed. The cleaning mechanism is not limited to the construction described above. For example, it is also allowable that the accumulating section 62a is not provided.

### Description of Exposure Step

With reference to Fig. 1, a plurality of shot areas are defined on the substrate P. The controller CONT of this embodiment moves the substrate stage PST while monitoring the output of the laser interferometer 56B so that the substrate P is advanced along a predetermined route with respect to the optical axis AX (projection area AR1) of the projection optical system PL, and successively exposes the plurality of shot areas in the step-and-scan manner. That is, a part of the pattern image of the mask M is projected onto the rectangular projection area AR1 by the projection optical system PL during the scanning exposure effected by the exposure apparatus EX. The mask M is moved at a velocity V in the X direction with respect to the illumination area, in synchronization with which the substrate P is moved at a velocity β•V (β represents the projection magnification) in the X direction with respect to the projection area AR1 via the substrate stage PST. After the completion of the exposure of one shot area on the substrate P, another shot area to be exposed next to the shot area is moved to the scanning start position by the step-movement of the substrate P. The scanning exposure process is successively performed for the respective shot areas thereafter while moving the substrate P in the step-and-scan manner as shown in Fig. 5.

The controller CONT shown in Fig. 1 drives the liquid supply mechanism 10 during the exposure process for the substrate P to perform the liquid supply operation for supplying the liquid onto the substrate P. The liquid 1, fed from the liquid supply section 11 of the liquid supply mechanism 10, flows through the supply tube 12, and then the liquid 1 is supplied onto the substrate P via the supply flow passages 82A, 82B formed in the nozzle member 30.
The liquid 1 supplied onto the substrate P flows under or below the projection optical system PL in conformity with the movement of the substrate P. For example, when the substrate P is moved in the +X direction during the exposure of a certain shot area, the liquid 1 flows under or below the projection optical system PL at a velocity approximately same as that of the substrate P in the +X direction which is the same as the direction of the substrate P. In this state, the exposure light EL, radiated from the illumination optical system IL and passing through the mask M, is irradiated onto the image plane side of the projection optical system PL, thereby exposing the substrate P with the pattern of the mask M via the projection optical system PL and the liquid 1 of the liquid immersion area AR2. The controller CONT performs the supply of the liquid 1 onto the substrate P by the liquid supply mechanism 10 when the exposure light EL is irradiated onto the image plane side of the projection optical system PL, i.e., during the exposure operation for the substrate P. The liquid immersion area AR2 is formed satisfactorily by continuing the supply of the liquid 1 by the liquid supply mechanism 10 during the exposure operation. On the other hand, the controller CONT performs the recovery of the liquid 1 on the substrate P by the liquid recovery mechanism 20 when the exposure light EL is irradiated onto the image plane side of the projection optical system PL, i.e., during the exposure operation for the substrate P. It is possible to suppress the expansion of the liquid immersion area AR2 by continuously executing the recovery of the liquid 1 by the liquid recovery mechanism 20 during the exposure operation (when the exposure light EL is irradiated onto the image plane side of the projection optical system PL).

In this embodiment, the liquid supply mechanism 10 supplies the liquid 1 onto the substrate P simultaneously from the both sides of the projection area AR1 through the supply ports 13, 14 during the exposure operation. Accordingly, the liquid 1, supplied from the supply ports 13, 14 onto the substrate P, is satisfactorily spread in the space between the substrate P and the lower end surface of the optical element 2 disposed at the terminal end of the projection optical system PL and the space between the substrate P and the lower surface of the nozzle member 30 (first member 31). The liquid immersion area AR2 is formed in a range which is wider than at least the projection area AR1. If the supply ports 13, 14 are connected to distinct liquid supply sections, the liquid supply amount per unit time, which is to be supplied from a position approaching the projection area AR1 in relation to the scanning direction, may be set to be greater than the liquid supply amount which is to be supplied from a position on the side opposite to the position approaching the projection area AR1.

It is also allowable that the recovery operation for recovering the liquid 1 by the liquid recovery mechanism 20 is not performed during the exposure operation, and that the flow passage of the recovery tube 22 is opened after the completion of the exposure to recover the liquid 1 on the substrate P. As an example, after the completion of the exposure for a certain shot area on the substrate P, the liquid 1 on the substrate P may be recovered by the liquid recovery mechanism 20 only during a partial period (at least a part of the stepping movement period) until the start of the exposure for another shot area to be exposed next to the certain shot area.

The controller CONT continues the supply of the liquid 1 by the liquid supply mechanism 10 during the exposure of the substrate P. By continuing the supply of the liquid 1 as described above, it is possible not only to fill the space between the projection optical system PL and the substrate P with the liquid 1 satisfactorily, but also to avoid the generation of the vibration of the liquid 1 (so-called the water hammer phenomenon). In this way, all of the shot areas on the substrate P can be exposed by the liquid immersion method.

The controller CONT moves the measuring stage MST to the position opposite to or facing the optical element 2 of the projection optical system PL, for example, during the exchange of the substrate P, and forms the liquid immersion area AR2 on the measuring stage MST. In this procedure, by moving the substrate stage PST and the measuring stage MST in a state that the substrate stage PST and the measuring stage MST are allowed to approach closely to each other, and by arranging one of the stages to be opposite to the optical element 2 when the one stage is being exchanged with the other of the stages, the liquid immersion area AR2 is moved between the substrate stage PST and the measuring stage MST. The controller CONT executes the measurement in relation to the exposure (for example, the baseline measurement) by using at least one of the measuring devices (measuring members) provided on the measuring stage MST in a state that the liquid immersion area AR2 is formed on the measuring stage MST.
Details of the operation for moving the liquid immersion area AR2 between the substrate stage PST and the measuring stage MST and the measuring operation of the measuring stage MST during the exchange of the substrate P are disclosed, for example, in International Publication No. 2005/074014 (corresponding to European Patent Application Publication No. 1713113) and International Publication No. 2006/013806. The exposure apparatus, which is provided with the substrate stage and the measuring stage, is disclosed, for example, in Japanese Patent Application Laid-open No. 11-135400 (corresponding to International Publication No. 1999/23692) and Japanese Patent Application Laid-open No. 2000-164504 (corresponding to United States Patent No. 6,897,963). The contents of United States Patent No. 6,897,963 are incorporated herein by reference within a range of permission of the domestic laws and ordinances of the designated state and the selected state.

### Description of Cleaning Operation

When the substrate P shown in Fig. 1 comes into contact with the liquid 1 of the liquid immersion area AR2 in the exposure step as described above, a part of components of the substrate P is eluted into the liquid 1 in some cases. For example, in a case that a chemical amplification type resist is used as the photosensitive material on the substrate P, the chemical amplification type resist includes a base resin, a photo acid generator (PAG) contained in the base resin, and an amine-based substance called "quencher". When the resist as described above comes into contact with the liquid 1, a part of the components of the resist, specifically, for example, PAG and the amine-based compound are sometimes eluted into the liquid 1. Also in a case that the base material of the substrate P itself (for example, the silicon substrate) comes into contact with the liquid 1, there is such a possibility that a part of components of the base material (for example, silicon) might be eluted into the liquid 1 depending on the substances constructing the base material.

As described above, there is such a possibility that the liquid 1, which comes into contact with the substrate P, might contain a minute foreign matter such as particles composed of the resist residue, the impurities generated from the substrate P, etc. There is also such a possibility that the liquid 1 might contain a minute foreign matter such as the impurities and the dust in the atmospheric air. Therefore, there is such a possibility that the liquid 1, which is recovered by the liquid recovery mechanism 20, might contain the foreign matter including various impurities, etc. In view of the above, the liquid recovery section 21 discharges the recovered liquid 1 to the outside. At least a part of the recovered liquid 1 may be cleaned by an internal processing apparatus, and then the cleaned liquid 1 may be returned to the liquid supply section 11.

For example, it is feared that the foreign matter such as the particles, which has a size larger than the meshes of the mesh filter 25 provided on the recovery port 24 of the nozzle member 30 shown in Fig. 1 and which enters into and mixes with the liquid 1 of the liquid immersion area AR2, might adhere to and remain on, for example, the surface (outer surface) of the mesh filter 25. Further, the foreign matter sometimes adheres, for example, to the liquid contact area of the nozzle member 30 other than the mesh filter 25. It is feared that the foreign matter, which remains as described above, might enter into and mix with the liquid 1 of the liquid immersion area AR2 again during the exposure of the substrate P. If the foreign matter, which entered into and mixed with the liquid 1, adheres onto the substrate P, it is feared that any deficiency including the shape defect, etc. might arise in the pattern to be formed on the substrate P.

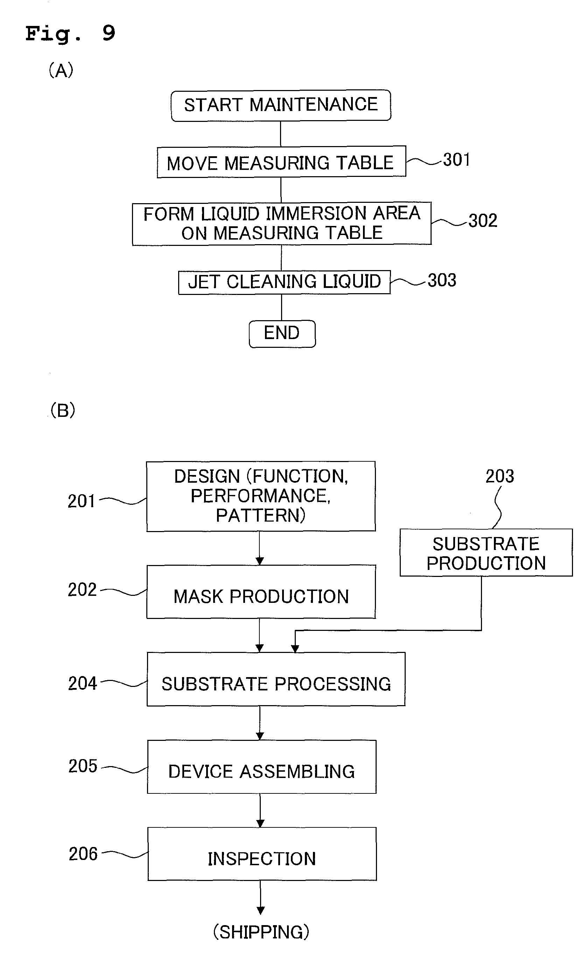

In view of the above, the exposure apparatus EX of this embodiment executes the cleaning of the foreign matter remaining on the nozzle member 30 during the maintenance performed periodically or requested, for example, by an operator for the liquid supply mechanism 10, the liquid recovery mechanism 20, etc. as follows in accordance with the sequence shown in Fig. 9(A). The particle level of the liquid recovered by the liquid recovery section 21 may be always monitored, and the following maintenance including the cleaning operation may be executed when the particle level exceeds a predetermined allowable range. For example, a particle counter which measures the number of foreign matters (particles) may be provided at an intermediate portion of the recovery tube 22 via a branch tube, and the number of particles in the recovered liquid may be monitored. As an example, the particle counter measures the number of particles in the liquid, such that the liquid in a predetermined volume is extracted at a predetermined sampling rate from the recovered liquid, the laser beam is irradiated onto the extracted liquid, and the image of the scattered light is subjected to the image processing. The following cleaning operation may be performed at every convenience during the exchange of the substrate P on the substrate stage PST. Further, for example, a portion of the nozzle member 30, which is dirtied to a great extent, may be previously detected by using the observing device 67 shown in Fig. 4, and only the portion dirtied to the great extent may be cleaned during the cleaning operation.

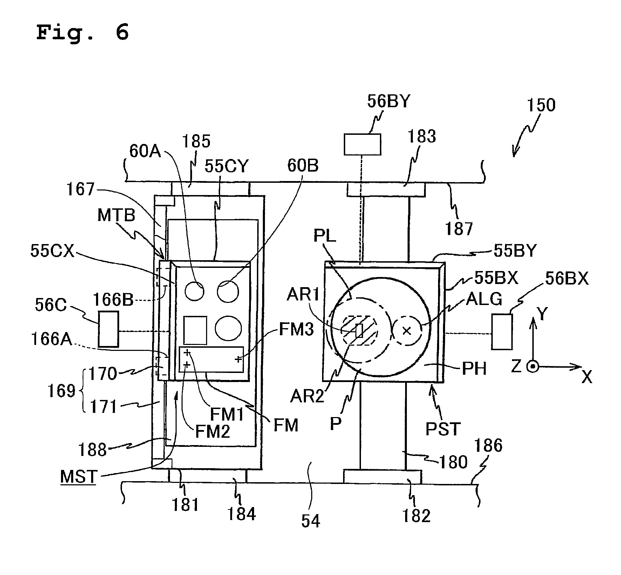

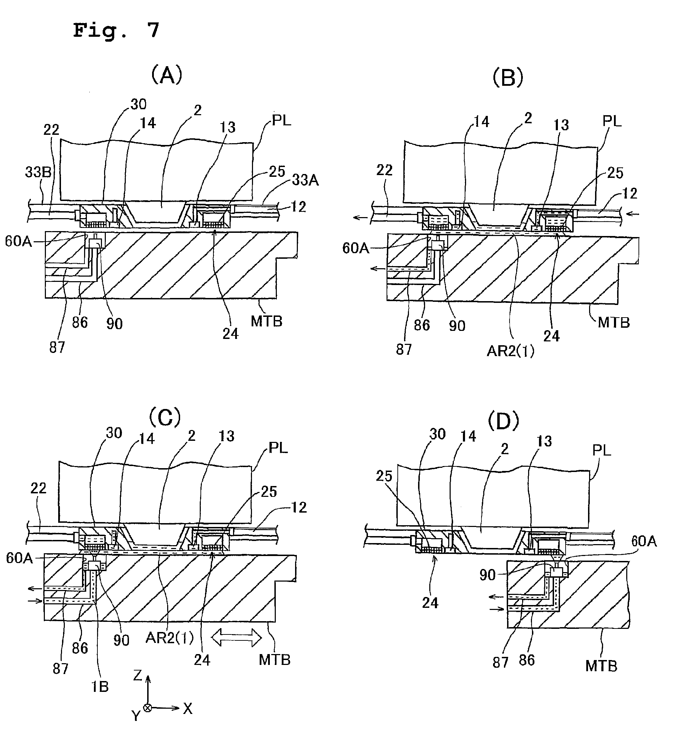

In the cleaning operation, in Step 301 shown in Fig. 9(A), the measuring table MTB of the measuring stage MST is allowed to make tight contact with (or make approach closely to) the substrate holder PH on the substrate stage PST as shown in Fig. 6 in a state that the radiation of the exposure light EL is stopped. Subsequently, the substrate stage PST and the measuring table MTB (measuring stage MST) are simultaneously moved in the +X direction to move the recess 60A of the measuring table MTB to the position disposed just under the projection optical system PL (moving step). After that, the substrate stage PST may be further retracted in the +X direction. As a result, as shown in Fig. 7(A), the jet nozzle portion 90 in the recess 60A on the measuring table MTB is moved to the bottom surface (moved to a position corresponding to the bottom surface or to a position opposite to or facing the bottom surface) of the recovery port 24 (mesh filter 25) of the nozzle member 30 which is supported by the unillustrated column mechanism via the support members 33A, 33B (coated with the liquid-repellent coat) to surround the optical element 2 disposed at the end portion of the projection optical system PL.

In this state, in Step 302 in the same manner as performed during the exposure in accordance with the liquid immersion method (provided that the exposure light EL is not radiated), the liquid 1 is supplied to the space between the upper surface of the measuring table MTB and the optical element 2 of the projection optical system PL and the bottom surface of the nozzle member 30 which surrounds the optical element 2, via the supply ports 13, 14 of the nozzle member 30 from the liquid supply mechanism 10 shown in Fig. 1, to form the liquid immersion area AR2 as shown in Fig. 7(B) (liquid immersion step). In this procedure, the valve 28 shown in Fig. 1 is closed and the valve 23 shown in Fig. 1 is opened to recover the liquid 1 in the liquid immersion area AR2 by the liquid recovery mechanism 20 so that the liquid immersion area AR2 is not spread to the outside of the nozzle member 30. The liquid 1 flows also into the recess 60A. Therefore, if necessary, the valve 64C shown in Fig. 4 may be opened to recover the liquid 1 in the recess 60A, via the recovery flow passage 87 and the piping 63C shown in Fig. 4, by the recovery device 65. By forming the liquid immersion area AR2 beforehand as described above, it is easy to exfoliate (remove) the foreign matter adhered to the nozzle member 30. It is also possible to suppress the spatter, scattering etc. of the cleaning liquid jetted from the jetting device 62 and allowed to collide against the nozzle member 30. In this state, the recovery of the liquid 1, which has been performed from the liquid immersion area AR2 by the liquid recovery mechanism 20 shown in Fig. 1, is stopped, and the supply of the liquid 1, which has been performed for the liquid immersion area AR2 from the liquid supply mechanism 10, is stopped. The liquid immersion area AR2 is maintained between the measuring table MTB and the optical element 2 and the bottom surface of the nozzle member 30 owing to the liquid repellence of the upper surface of the measuring table MTB and the surface tension of the liquid 1.

Subsequently, it is assumed that the jetting device 62 shown in Fig. 4 is used. In Step 303, in accordance with the control by the controller 61, the valve 64B is closed and the valve 64A is opened to jet the cleaning liquid 1B toward the mesh filter 25 in the recovery port 24 of the nozzle member 30 as shown in Fig. 7(C) from the jetting device 62 via the piping 63A, the supply flow passage 86, and the jet nozzle portion 90. Concurrently with this, the cleaning liquid 1B, which is allowed to inflow into the recess 60A, is recovered by the recovery device 65 via the recovery flow passage 87 and the piping 63C shown in Fig. 4. The jetting of the cleaning liquid 1B jetted from the jet nozzle portion 90 and the recovery of the cleaning liquid 1B in the recess 60A are performed as described above, while the measuring stage MST shown in Fig. 4 is driven in the X direction and the Y direction. By doing so, as shown in Fig. 7(C), the jet nozzle portion 90 is moved relative to and along the supply ports 13, 14 and the rectangular frame-shaped recovery port 24 of the nozzle member 30. Accordingly, the cleaning liquid 1B is jetted against the entire surfaces of the mesh filter 25 and the supply ports 13, 14 (cleaning step). As shown in Fig. 7(D), in a case that the upper surface of the measuring table MTB is deviated from or does not face a part of the bottom surface of the nozzle member 30, the liquid 1 in the liquid immersion area AR2 may be recovered by the liquid recovery mechanism 20 shown in Fig. 1.

As a result, much or a great part of the foreign matters adhered to the mesh filter 25 (recovery port 24) in the nozzle member 30 and the interior of the supply ports 13, 14 are mixed or dissolved in the cleaning liquid 1B. The foreign matters are recovered by the recovery device 65 shown in Fig. 4 together with the cleaning liquid 1B. If necessary, the cleaning operation ranging from Fig. 7(A) to Fig. 7(D) may be repeated a plurality of times. The supply and recovery operations for the liquid 1 with respect to the liquid immersion area AR2 shown in Fig. 7(B) (Step 302) and the jetting operation for jetting the cleaning liquid 1B from the jet nozzle portion 90 shown in Fig. 7(C) (Step 303) may be executed concurrently at least partially. Further, the cleaning liquid 1B may be recovered by the liquid recovery mechanism 20 instead of the recovery of the cleaning liquid 1B by the recovery device 65 or concurrently therewith. The supply and recovery operations for supplying and recovering the liquid 1 with respect to the liquid immersion area AR2 may be continuously performed during the cleaning operation (especially during the jetting operation for jetting the cleaning liquid 1B).

The function, etc. of the cleaning operation of this embodiment are summarized as follows.
A1: As shown in Fig. 7(C), the cleaning liquid 1B is supplied to the recovery port 24 and the supply ports 13, 14 of the nozzle member 30. Therefore, it is possible to remove, together with the cleaning liquid 1B, at least a part of the foreign matter accumulated in the nozzle member 30 or deposited on the surface of the nozzle member 30 when the exposure is performed by the liquid immersion method. In this procedure, the liquid immersion area AR2 is formed previously or partially concurrently. Therefore, it is possible to easily exfoliate and remove the foreign matter adhered to the nozzle member 30. Further, it is also possible to avoid the contamination or pollution of the exposure apparatus which would be otherwise caused due to the spatter, scattering, etc. of the cleaning liquid. Therefore, it is possible to efficiently perform the maintenance for the liquid supply mechanism 10 and the liquid recovery mechanism 20 (as well as the maintenance for the exposure apparatus) or the cleaning of the nozzle member 30. As a result, the amount of the foreign matter is decreased in the liquid of the liquid immersion area AR2 on the substrate P in the exposure step to be performed thereafter. Therefore the shape error of the pattern to be transferred, etc. is reduced, and it is possible to perform the exposure highly accurately.

For example, with reference to Fig. 1, in a case that the liquid supply ports 13, 14 and the recovery port 24 are provided on distinct nozzle members, it is also allowable that only one of the nozzle members is cleaned in the cleaning step. Further, in relation to the exposure apparatus EX, it is also allowable that the cleaning liquid is jetted from the jet nozzle portion 90 against the cleaning objective portion including at least a part of the portion (liquid contact portion) which has the possibility which comes into contact with the liquid 1 during the exposure based on the liquid immersion method. Also in this case, the amount of the foreign matter in the liquid is decreased during the exposure to be performed thereafter. The cleaning objective portion is not limited to other liquid contact portion of the nozzle member 30 different from the mesh filter 25 (recovery port 24) and the supply ports 13, 14. The cleaning objective portion may be a member which is different from the nozzle member 30, for example, a liquid contact portion of the optical element 2 ,etc.

A2: In this embodiment, the cleaning liquid 1B is jetted from the jet nozzle portion 90. Therefore, it is possible to efficiently remove the foreign matter adhered to the nozzle member 30. The cleaning liquid 1B may be jetted or spouted toward the cleaning objective portion from a simple jetting or spouting port, without using the jet nozzle portion 90. For example, in order to enhance the cleaning effect with the cleaning liquid 1B, the measuring table MTB may be vibrated in at least one of the X direction, the Y direction, and the Z direction when the cleaning liquid 1B is jetted against the nozzle member 30. The cleaning condition described above may include the presence or absence of the vibration of the measuring table MTB and/or the vibration condition.

A3: In this embodiment, the cleaning liquid, which is supplied from the jetting device 62 shown in Fig. 4, is jetted from the jet nozzle portion 90. However, a mixture of the cleaning liquid and the gas, which is supplied from the mixing jetting device 66 shown in Fig. 4, may be jetted from the jet nozzle portion 90. In this case, it is possible to enhance the cleaning effect by the bubbles (cavitation bubbles). The gas such as nitrogen may be dissolved in the cleaning liquid.
A4: The nozzle member 30 of this embodiment is arranged to surround the optical element 2 closest to the image plane of the projection optical system PL. Further, the mesh filter 25 is provided for the recovery port 24 of the nozzle member 30. In the cleaning step described above, the cleaning liquid 1B is jetted against the mesh filter 25, etc. In this procedure, the cleaning liquid 1B may be also jetted against the lower surface of the optical element 2. By doing so, it is also possible to remove the foreign matter adhered to the optical element 2.

A5: The cleaning operation described above includes the operation for recovering the cleaning liquid 1B jetted from the jet nozzle portion 90 (recovery step). Therefore, it is possible to discharge the cleaning liquid 1B to and with which the foreign matter entered and mixed, to the outside. In this embodiment, the recovery mechanism for the cleaning liquid 1B (mechanism including the recovery device 65 shown in Fig. 4) is provided on the side of the measuring stage MST. However, the sucking port for the cleaning liquid may be provided, for example, in the vicinity of the nozzle member 30. In this case, the liquid recovery section 21 shown in Fig. 1 can be used also as a device or apparatus for sucking the cleaning liquid form the sucking port. Accordingly, it is possible to simplify the construction of the measuring stage MST (movable member).

A6: In the embodiment described above, the type of the liquid 1 for the liquid immersion exposure is different from the type of the cleaning liquid 1B. Therefore, a liquid such as a solvent, which has the high cleaning effect, can be used as the cleaning liquid 1B.
The liquid 1 itself can be used also as the cleaning liquid 1B. In this case, the liquid supply section 11 shown in Fig. 1 can be used also as the cleaning liquid supply section 26 shown in Fig. 1 and the accumulating section 62a of the jetting device 62 shown in Fig. 4. It is possible to simplify the construction of the supply mechanism for the liquid and the cleaning liquid.

### Description of Cleaning Operation of Another Embodiment

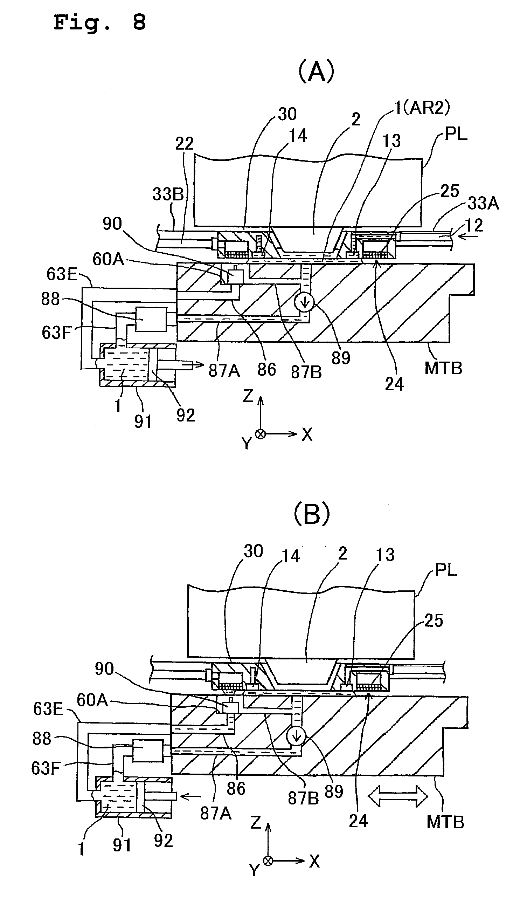

Next, an explanation will be made with reference to Fig. 8 about another exemplary embodiment of the present invention. An exposure apparatus of this embodiment is basically constructed in the same manner as the exposure apparatus EX shown in Fig. 1. However, the exposure apparatus of this embodiment differs in the cleaning mechanism provided on the side of the measuring stage MST shown in Fig. 1 in order to clean the nozzle member 30. In the following description, components or parts shown in Fig. 8, which correspond to those shown in Fig. 4 and Fig. 7(A), are designated by the same reference numerals, any detailed explanation of which will be omitted.

Fig. 8(A) shows a sectional view of the nozzle member 30 provided to surround the optical element 2 of the projection optical system PL and a measuring table MTB of a measuring stage MST of this embodiment (see Fig. 1). With reference to Fig. 8(A), the liquid 1 is supplied from the liquid supply mechanism 10 shown in Fig. 1 via the nozzle member 30 during the exposure based on the liquid immersion method and the liquid 1 is recovered by the liquid recovery mechanism 20, thereby forming the liquid immersion area AR2 to include the space between the optical element 2 of the projection optical system PL and the bottom surface of the nozzle member 30 and the surface of the substrate (not shown) opposite thereto.

With reference to Fig. 8(A), a recovery flow passage 87A is formed to extend from a central portion in the X direction (scanning direction) of the upper surface of the measuring-table body 159 to a side surface in the -X direction of the measuring table MTB. A check valve 89 is provided at an intermediate portion of the recovery flow passage 87A so that the liquid is not allowed to flow upwardly (in the +Z direction). Further, a recess 60A is formed on the upper surface of the measuring table 159 in the vicinity of an opening communicated with the recovery flow passage 87A. A jet nozzle portion 90 is fixed to a central portion of the recess 60A. The bottom portion of the recess 60A is connected by a recovery flow passage 87B to a portion of the recovery flow passage 87A located above the check valve 89.

An inflow port for the liquid, which is disposed at the bottom portion of the jet nozzle portion 90 in the recess 60A, is communicated with a cylinder portion 91 for accumulating the liquid via a supply flow passage 86 formed in the measuring table MTB and an external supply tube 63E. The recovery flow passage 87A is communicated with the cylinder portion 91 from the side surface of the measuring table MTB via a recovery tube 63F to which a dust-removing or dust-proof filter 88 is installed. A piston portion 92, which is pushed and pulled by an unillustrated driving section (controlled by the controller 61 shown in Fig. 4), is installed to the cylinder portion 91. By pulling the piston portion 92, it is possible to accumulate the liquid 1 of the liquid immersion area AR2 in the cylinder portion 91 via the recovery tube 63F. By pushing the piston portion 92, it is possible to jet (spout) the liquid 1 in the cylinder portion 91 upwardly from the jet nozzle portion 90 via the supply tube 63E. Therefore, the accumulating mechanism for the liquid 1 is constructed to include the recovery flow passage 87A, the check valve 89, the recovery tube 63F, the cylinder portion 91, the piston portion 92, and a driving section (not shown) therefor. The jetting device for the liquid 1 is constructed to include the jet nozzle portion 90, the supply flow passage 86, the supply tube 63E, the cylinder portion 91, the piston portion 92, and a driving section (not shown) therefor. The cleaning mechanism of this embodiment is constructed to include the accumulating mechanism and the jetting device.

In this embodiment, the accumulating mechanism for the liquid 1, which includes the recovery tube 63F, the cylinder portion 91, and the piston portion 92, is used also as the recovery mechanism for the liquid jetted from the jet nozzle portion 90 and allowed to inflow into the recess 60A, together with the recovery flow passage 87B. Also in this embodiment, a temperature adjusting section for adjusting the temperature of the liquid 1 may be provided, for example, between the supply tube 63E and the cylinder portion 91 to adjust the temperature of the liquid jetted from the jet nozzle portion 90. Further, a mixing section for mixing (or dissolving) a gas such as the air into (or in) the liquid 1 may be provided, for example, between the supply tube 63E and the cylinder portion 91 to mix the gas (bubbles) into the liquid jetted from the jet nozzle portion 90. Further, a cleaning liquid, which is obtained by mixing the liquid 1, for example, with a solvent such as thinner or IPA, may be jetted from the jet nozzle portion 90. The cleaning mechanism of this embodiment is not limited to the construction described above.

Next, an explanation will be made with reference to Figs. 8(A) and 8(B) about an exemplary operation to be performed in a case that the nozzle member 30 shown in Fig. 1 is cleaned by using the cleaning mechanism of this embodiment when the maintenance is performed, for example, for the liquid supply mechanism 10 and the liquid recovery mechanism 20 shown in Fig. 1.
At first, as shown in Fig. 8(A), the measuring stage MST is driven in a state that the radiation of the exposure light EL is stopped so as to move the opening of the recovery flow passage 87A of the measuring table MTB to the bottom surface (to a position corresponding to the bottom surface or to a position opposite to or facing the bottom surface) of the projection optical system PL (moving step). In this state, it is assumed that the piston portion 92 of the cylinder portion 91 is pushed to the limit, and the liquid 1 is not accumulated in the cylinder portion 91. Subsequently, in the same manner as in the exposure based on the liquid immersion method (provided that the exposure light EL is not radiated), the liquid 1 is supplied to the space between the upper surface of the measuring table MTB and the optical element 2 of the projection optical system PL and the bottom surface of the nozzle member 30 surrounding the optical element 2, via the supply ports 13, 14 of the nozzle member 30 from the liquid supply mechanism 10 shown in Fig. 1, to form the liquid immersion area AR2 (liquid immersion step). The piston portion 92 of the cylinder portion 91 is gradually pulled to the limit so that the liquid 1 in the liquid immersion area AR2 is accumulated in the cylinder portion 91 via the recovery flow passage 87A and the recovery tube 63F (accumulating step). During this process, the liquid 1 is supplied from the liquid supply mechanism 10 shown in Fig. 1, at a volume of not less than the volume of the cylinder portion 91.

Subsequently, as shown in Fig. 8(B), the piston portion 92 of the cylinder portion 91 is gradually pushed so that the liquid 1 accumulated in the cylinder portion 91 is jetted toward the mesh filter 25 in the recovery port 24 of the nozzle member 30, via the supply tube 63E, the supply flow passage 86, and the jet nozzle portion 90. The measuring stage MST shown in Fig. 4 is driven in the X direction and the Y direction while jetting the liquid 1 from the jet nozzle portion 90 as described above, thereby moving, as shown in Fig. 8(B), the jet nozzle portion 90 along and relative to the rectangular frame-shaped recovery port 24 and the supply ports 13, 14 of the nozzle member 30. Accordingly, the liquid 1 is jetted against the entire surfaces of the mesh filter 25 and the supply ports 13, 14 (cleaning step). In this procedure, the liquid 1 does not cause any backflow in the recovery flow passage 87A, because the check valve 89 is provided.

When the liquid 1 in the cylinder portion 91 is decreased in the middle of or during the process, then the liquid 1 may be supplied to the liquid immersion area AR2 via the nozzle member 30 from the liquid supply mechanism 10 shown in Fig. 1, and the interior of the cylinder portion 91 may be supplemented with the liquid 1 by pulling the piston portion 92 as shown in Fig. 8(A). During this process, the liquid 1 allowed to inflow into the recess 60A is also recovered. The liquid 1 can be jetted from the jet nozzle portion 90 again by pulling the piston portion 92 thereafter. As a result, much or greater parts of the foreign matters adhered to the mesh filter 25 (recovery port 24) in the nozzle member 30 and the interior of the supply ports 13, 14 are mixed into or dissolved in the liquid 1. The foreign matters can be recovered into the cylinder portion 91 shown in Fig. 8(A) together with the liquid 1. By exchanging the dust-removing filter 88 periodically, or by providing a water vent valve for the cylinder portion 91 beforehand, and by discharging the liquid in the cylinder portion 91 to the outside, if necessary, it is possible to prevent the liquid jetted from the jet nozzle portion 90 from being contaminated or polluted with any foreign matter.

The function, etc. of the cleaning operation of this embodiment are summarized as follows.
A7: The liquid 1, which is supplied from the liquid supply mechanism 10 shown in Fig. 1 via the nozzle member 30 to the liquid immersion area AR2, is used as the cleaning liquid for cleaning the nozzle member 30. Therefore, it is possible to simplify the supply mechanism for the cleaning liquid. This construction is equivalent to the construction in which the liquid 1 is previously supplied to the liquid contact portion. Therefore, it is possible to efficiently remove the foreign matter adhered to the interior of the nozzle member 30. Therefore, it is possible to efficiently perform the maintenance for the liquid supply mechanism 10 and the liquid recovery mechanism 20 (as well as the maintenance for the exposure apparatus) or the cleaning of the nozzle member 30.

Also in the exposure apparatus EX of this embodiment, the liquid may be jetted from the jet nozzle portion 90 against the cleaning objective portion including at least a part of the liquid contact portion. With this also, the amount of the foreign matter is decreased in the liquid during the exposure to be performed thereafter. The cleaning objective portion is not limited to other liquid contact portion of the nozzle member 30 different from the mesh filter 25 (recovery port 24) and the supply ports 13, 14. The cleaning objective portion may be a member different from the nozzle member 30, for example, a liquid contact portion of the optical element 2, etc.
A8: In this embodiment, as shown in Fig. 8(A), the liquid 1 is jetted from the jet nozzle portion 90, and hence the high cleaning effect is obtained. It is also possible to use, for example, a member which merely jets or spouts the liquid 1, instead of the jet nozzle portion 90.

A9: In this embodiment, as shown in Fig. 8(A), the check valve 89 is provided in the recovery flow passage 87A. Therefore, the cylinder portion 91 and the piston portion 92 can be used also for the accumulating mechanism and the jetting device for the liquid 1. For example, instead of the check valve 89, it is allowable to provide a valve which opens/closes the recovery tube 63F.
The cylinder portion 91 and the piston portion 92 may be individually provided for each of the accumulating mechanism and the jetting device for the liquid 1. In this case, for example, by connecting two cylinder portions to each other via a check valve beforehand, it is possible to perform the accumulating step of accumulating the liquid 1 described above and the cleaning step of using the liquid 1 concurrently at least partially.

It is also possible to provide the jetting mechanism for the liquid 1 on the measuring stage MST. In this case, as an example, with reference to Fig. 8(A), a small-sized pump for jetting the liquid 1 is provided on the measuring table MTB beforehand. The operation, in which the liquid 1 is supplied from the liquid supply mechanism 10 shown in Fig. 1 via the supply ports 13, 14 shown in Fig. 8(A), and the supplied liquid 1 is jetted by the small-sized pump against the bottom surface of the nozzle member 30, etc. (at least a part of the liquid contact portion), may be continuously repeated. Alternatively, the liquid 1, which is jetted on the measuring table MTB, may be circulated and jetted again. In the case of the construction in which the small-sized pump is provided on the measuring table MTB, it is possible to miniaturize the stage mechanism as a whole.

In the embodiments described above, the measuring stage MST is moved to move the jet nozzle portion 90, which jets the cleaning liquid 1B or the liquid 1, relative to the nozzle member 30. However, it is allowable that the nozzle member 30 is made to be movable; and that the nozzle member 30 may be moved, relative to the jet nozzle portion 90, on the measuring stage MST (or the substrate stage PST) while the measuring stage MST does not move. In this case, both of the nozzle member 30 and the measuring stage MST may be moved. Further, the liquid of the liquid immersion area AR2 may be vibrated to enhance the cleaning effect, instead of the relative movement of the nozzle member 30 and the measuring stage MST or in combination therewith.
It is possible to use, as the member for vibrating the liquid, for example, an ultrasonic vibrator including, for example, a piezoelectric ceramics (those based on the barium titanate system, the lead titanate zirconate system, etc. (so-called PZT)) or a ferrite vibrator (electrostrictive vibrator). In this case, the vibration of the liquid of the liquid immersion area AR2 and the jetting of the cleaning liquid 1B or the liquid 1 may be performed concurrently at least partially. Alternatively, the liquid of the liquid immersion area AR2 may be vibrated prior to the jetting of the cleaning liquid 1B or the liquid 1.

In the embodiments described above, the liquid immersion area AR2 is formed with the liquid 1 during the cleaning operation. However, the liquid immersion area AR2 may be formed with a liquid which is different from the liquid for the liquid immersion exposure, for example, the cleaning liquid supplied from the cleaning liquid supply section 26 or the cleaning mechanism described above. In this case, the cleaning liquid, which is of the same type as that of the cleaning liquid of the liquid immersion area AR2, may be jetted. Alternatively, it is also allowable to jet the cleaning liquid of the different type or the liquid for the liquid immersion exposure. Further, in the embodiments described above, the liquid immersion area AR2 is formed during the cleaning operation. However, the liquid contact portion may be cleaned without forming the liquid immersion area AR2. In this case, a member may be arranged to suppress or avoid the scattering or spatter of the liquid colliding against the liquid contact portion, or a gas barrier may be formed to surround the cleaning objective area of the liquid contact portion. In the embodiments described above, the cleaning mechanism adopts the liquid jetting system. However, in a case that the cleaning condition can be changed for the cleaning mechanism, the cleaning mechanism may adopt a cleaning system different from the liquid jetting system. In the embodiment described above, the cleaning objective is the liquid contact portion which comes into contact with the liquid 1 for the liquid immersion exposure. However, if necessary, a portion, which does not come into contact with the liquid 1, may be designated as the cleaning objective.

In the embodiments described above, the mesh filter 25, which is arranged at the recovery port 24 of the nozzle member 30, may be exchangeable. In a case that the porous member, which is installed to the recovery port 24, etc., is the mesh filter 25 (mesh-shaped filter member), then the foreign matter can be removed efficiently, and the adhered foreign matter can be also cleaned out with ease.

However, the porous member, which is arranged at the recovery port 24 of the nozzle member 30, etc., is not limited to the mesh filter 25. That is, it is also possible to use, for example, a porous member formed of sponge, etc. or a porous member or the like provided with an exchangeable cartridge type filter (for example, a ceramics filter), instead of the mesh filter 25. The portion, at which the porous member is arranged, is not limited to only the recovery port 24 or the like.
In a case that the mesh filter 25 (as well as any other equivalent porous member) in the nozzle member 30 is exchangeable, then upon exchanging the mesh filter 25, to which the foreign matter is adhered, with an unused (or cleaned) another mesh filter, then, for example, it is desirable that the controller CONT shown in Fig. 1 drives the liquid recovery mechanism 20, and all of the liquid 1 is discharged beforehand from the flow passages for the liquid 1 including the recovery flow passage 84 and the supply flow passages 82A, 82B in the nozzle member 30 shown in Fig. 3. This makes it possible to avoid the remaining in the nozzle member 30 of the foreign matter eluted from the mesh filter 25 into the liquid 1 during the exchange of the mesh filter 25.

In the embodiments described above, the measuring stage MST includes, as the measuring members, the reference mark and at least one of the plurality of measuring devices described above in addition to the cleaning mechanism. However the type and/or the number, etc. of the measuring member or members to be provided on the measuring stage MST is not limited to this. As for the measuring member, it is also allowable to provide, for example, a transmittance measuring device for measuring the transmittance of the projection optical system PL. Only a part or parts of the measuring devices may be provided on the measuring stage MST, and the remaining part or parts may be provided outside the measuring stage MST. Further, at least one measuring device may be provided on the substrate stage PST.

In the embodiments described above, at least a part of the cleaning mechanism is provided on the measuring stage MST. However, at least a part of the cleaning mechanism may be provided on a movable stage (movable member, movable element) which is independent from the measuring stage MST. The movable stage may be the substrate stage PST, or the movable stage may be different from the substrate stage PST. In this case, for example, in order to maintain the liquid immersion area AR2 described above during the exchange of the substrate P, the movable stage may be arranged to be opposite to the projection optical system PL by being exchanged with the substrate stage PST.

In the embodiments described above, the interferometer system (56A to 56C) is used to measure the respective pieces of position information about the mask stage RST, the substrate stage PST, and the measuring stage MST. However, there is no limitation to this. For example, it is also allowable to use an encoder system for detecting a scale (diffraction grating) provided on each of the stages. In this case, it is preferable that a hybrid system including both of the interferometer system and the encoder system is provided, and the measurement result of the encoder system is calibrated (subjected to the calibration) by using the measurement result of the interferometer system. The position control of the stage may be performed by switchingly using the interferometer system and the encoder system or using both of the interferometer system and the encoder system.

In the embodiments described above, the substrate holder PH may be formed integrally with the substrate stage PST. Alternatively, the substrate holder PH and the substrate stage PST may be constructed separately, and the substrate holder PH may be fixed to the substrate stage PST, for example, by the vacuum attraction, etc.
The present invention is also applicable to an exposure apparatus in which various measuring devices are provided on the substrate stage PST (exposure apparatus not provided with the measuring stage MST). Further, only a part or parts of various measuring devices may be provided on the measuring stage MST or the substrate stage PST, and the remaining part or parts may be provided at the outside of the measuring stage MST or the substrate stage PST or on another member different from the measuring stage MST or the substrate stage PST. In the case of these constructions, for example, the cleaning mechanism including the jet nozzle portion 90 shown in Fig. 4 may be provided on the side of the substrate stage PST.
In the embodiments described above, the irradiation area (including the illumination area and the projection area AR1 described above) of the exposure light EL is rectangular. However, there is no limitation to this. For example, the radiation area may be circular arc-shaped.
The irradiation area (AR1, etc.) is defined to include the optical axis AX in the field of the projection optical system PL. However, there is no limitation to this. For example, the irradiation area (AR1, etc.) may be defined eccentrically, without including the optical axis AX.

As shown in Fig. 9(B), the microdevice such as the semiconductor device is produced by performing a step 201 of designing the function and the performance of the microdevice; a step 202 of manufacturing a mask (reticle) based on the designing step; a step 203 of producing a substrate as a base material for the device; a substrate-processing step 204 including a step of exposing the substrate with the pattern of the mask by the exposure apparatus EX of the embodiment described above, a step of developing the exposed substrate, a step of heating (curing) and etching the developed substrate, etc.; a step 205 of assembling the device (including processing processes such as a dicing step, a bonding step, and a packaging step, etc.); an inspection step 206; etc.

In the respective embodiments described above, the substrate P is not limited to only the semiconductor wafer for producing the semiconductor device. Those applicable include a glass substrate for a display device, a ceramic wafer for a thin film magnetic head, a master plate (synthetic silica glass, silicon wafer) for the mask or the reticle to be used for the exposure apparatus, a film member, etc. Further, the shape of the substrate P is not limited to only the circular shape, and may be other shape including rectangular shapes, etc.
In the embodiments described above, the mask, on which the transferring pattern is formed, is used. However, instead of using such a mask, it is also appropriate to use an electronic mask which forms a transmissive pattern or a reflective pattern based on an electronic data of the pattern to be subjected to the exposure as disclosed, for example, in United States Patent No. 6,778,257. The electronic mask is also referred to as "variable shaped mask" ("active mask", or "image generator"), which includes DMD (Digital Micro-mirror Device), etc. as one of the no light-emitting image display device (spatial light modulator).

DMD has a plurality of reflecting elements (micro-mirrors) which are driven based on predetermined electronic data. The plurality of reflecting elements are arranged in a two-dimensional matrix form on a surface of DMA, and are driven individually (element by element) to reflect and deflect the exposure light. Angles of the reflecting surfaces of the respective reflecting elements are adjusted. The operation of DMD may be controlled by the controller CONT. The controller CONT drives the reflecting elements of DMD based on the electronic data (pattern information) corresponding to the pattern to be formed on the substrate P, and patterns the exposure light radiated by the illumination system IL by the reflecting elements. By using DMD, it is unnecessary to perform the exchange operation for the mask and the positional adjustment operation for the mask on the mask stage when the pattern is changed, as compared with a case that the exposure is performed by using the mask (reticle) in which the pattern is formed. Therefore, it is possible to perform the exposure operation more efficiently. In the exposure apparatus using the electronic mask, it is enough that the substrate is merely moved in the X axis direction and the Y axis direction by the substrate stage, without providing the mask stage. The exposure apparatus using DMD is disclosed, for example, in Japanese Patent Application Laid-open Nos. 8-313842 and 2004-304135 in addition to United States Patent No. 6,778,257 described above. The contents of United States Patent No. 6,778,257 are incorporated herein by reference within a range of permission of the domestic laws and ordinances of the designated state or the selected state.

As for the exposure apparatus EX, the present invention is also applicable to a scanning type exposure apparatus (scanning stepper) of the step-and-scan system which performs the scanning exposure with the pattern of the mask M by synchronously moving the mask M and the substrate P as well as a projection exposure apparatus (stepper) of the step-and-repeat system which performs the full field exposure with the pattern of the mask M in a state that the mask M and the substrate P are allowed to stand still, while successively step-moving the substrate P. As for the type of the exposure apparatus EX, the present invention is not limited to the exposure apparatus for the semiconductor device production which exposes the substrate P with the semiconductor device pattern. The present invention is also widely applicable, for example, to an exposure apparatus for producing a liquid crystal display device or for producing a display as well as an exposure apparatus for producing a thin film magnetic head, a micromachine, MEMS, a DNA chip, an image pickup device (CCD), a reticle, or a mask, etc.
The present invention is also applicable to an exposure apparatus of the multi-stage type provided with a plurality of substrate stages as disclosed, for example, in Japanese Patent Application Laid-open No. 10-163099, Japanese Patent Application Laid-open No. 10-214783 (corresponding to United States Patent Nos. 6,341,007, 6,400,441, 6,549,269, and 6,590,634), Published Japanese Translation of PCT International Publication for Patent Application No. 2000-505958 (corresponding to United States Patent No. 5,969,441), and United States Patent No. 6,208,407. The contents of the United States Patents described above are incorporated herein by reference within a range of permission of the domestic laws and ordinances of the designated state or the selected state in relation to the exposure apparatus of the multi-stage type.

In the case of the projection optical system of the embodiment described above, the optical path space (liquid immersion space), which is disposed on the image plane side of the optical element arranged at the end portion, is filled with the liquid. However, it is also possible to adopt a projection optical system in which the optical path space disposed on the mask side of the optical element arranged at the end portion is also filled with the liquid, as disclosed, for example, in International Publication No. 2004/019128. Further, the present invention is also applicable to an exposure apparatus of the liquid immersion type in which the liquid immersion area, which is between the projection optical system and the substrate, is held or retained by an air curtain arranged therearound as disclosed, for example, in International Publication No. 2004/093159 and United States Patent Application Publication No. 2006/0023189A1.

The present invention is also applicable to an exposure apparatus in which a line-and-space pattern is formed on the substrate P by forming interference fringes on the substrate P as disclosed, for example, in International Publication No. 2001/035168. Also in this case, the exposure light is irradiated onto the substrate P via the liquid between the optical member and the substrate P.
Further, the present invention is also applicable to an exposure apparatus in which patterns of two masks are combined on the substrate via the projection optical system, and one shot area on the substrate is subjected to the double exposure substantially simultaneously by one time of the scanning exposure as disclosed, for example, in Published Japanese Translation of PCT International Publication for Patent Application No. 2004-519850 (corresponding to United States Patent No. 6,611,316).

In the embodiments described above, it is not necessarily indispensable that the liquid supply section and/or the liquid recovery section is/are provided on the exposure apparatus. For example, an equipment of the factory or the like in which the exposure apparatus is installed may be substitutively used. The structures required for the liquid immersion exposure are not limited to the structures as described above. It is possible to use those described, for example, in European Patent Publication No. 1420298, International Publication Nos. 2004/055803 and 2004/057590, International Publication No. 2005/029559 (corresponding to United States Patent Publication No. 2006/0231206), International Publication No. 2004/086468 (corresponding to United States Patent Publication No. 2005/0280791), and Japanese Patent Application Laid-open No. 2004-289126 (corresponding to United States Patent No. 6,952,253). The contents of the United States Patents and United States Patent Publications, etc. described above are incorporated herein by reference within a range of permission of the domestic laws and ordinances of the designated state or the selected state in relation to the liquid immersion mechanism of the liquid immersion exposure apparatus and any apparatus equipped thereto.

In the embodiments described above, it is also allowable to use, as the liquid 1 to be used for the liquid immersion method, a liquid having the refractive index with respect to the exposure light higher than that of water, for example, those having the refractive index of about 1.6 to 1.8. The liquid 1, which has the refractive index (for example, not less than 1.5) higher than that of pure water, includes, for example, predetermined liquids having the C-H bond or the O-H bond such as isopropanol having a refractive index of about 1.50 and glycerol (glycerin) having a refractive index of about 1.61, predetermined liquids (organic solvents) such as hexane, heptane, and decane, and decalin (decahydronaphthalene) having a refractive index of about 1.60. As for the liquid 1, it is also allowable to use those obtained by mixing arbitrary two or more liquids of the foregoing liquids, and it is also allowable to use those obtained by adding (mixing) at least one of the foregoing liquids to (with) pure water. Further, as for the liquid 1, it is also allowable to use those obtained by adding (mixing) base or acid such as H⁺, Cs⁺, K⁺, Cl⁻, SO₄²⁻, and PO₄²⁻ to (with) pure water, and it is also allowable to use those obtained by adding (mixing) fine particles of Al oxide or the like to (with) pure water. As for the liquid 1, it is preferable to use those which have small coefficient of light absorption, which have small temperature dependency, and which are stable against the photosensitive material (or the top coat film, the antireflection film, etc.) coated on the surface of the substrate P and/or the projection system PL. As for the liquid 1, it is also possible to use a supercritical fluid. As for the substrate P, it is possible to provide, for example, the top coat film which protects the photosensitive material and the base material from the liquid.

On the other hand, the optical element (terminal end optical element) 2 of the projection optical system PL may be formed of, for example, silica glass (silica) or a single crystal material of a fluorine compound such as barium fluoride, strontium fluoride, lithium fluoride, and sodium fluoride, instead of calcium fluoride. Alternatively, the optical element (terminal end optical element) 2 may be formed of a material having a refractive index (for example, not less than 1.6) higher than those of silica glass and calcium fluoride. Those usable as the material having the refractive index of not less than 1.6 include sapphire, germanium dioxide, etc. as disclosed, for example, in International Publication No. 2005/059617, and potassium chloride (refractive index: about 1.75) as disclosed in International Publication No. 2005/059618.

When the liquid immersion method is used, it is also appropriate that the optical path disposed on the object plane side of the terminal end optical element is also filled with the liquid, in addition to the optical path disposed on the image plane side of the terminal end optical element as disclosed, for example, in International Publication No. 2004/019128 (corresponding to United States Patent Publication No. 2005/0248856). Further, a thin film, which has the lyophilic or liquid-attractive property and/or the anti-dissolution function, may be formed on a part (including at least the contact surface which comes into contact with the liquid) or all of the surface of the terminal end optical element. The silica glass has high affinity for the liquid, and any anti-dissolution film is not required for the silica glass as well. However, for calcium fluoride, it is preferable to form at least the anti-dissolution film..

In the respective embodiments described above, the ArF excimer laser is used as the light source for the exposure light EL. However, it is also allowable to use a high harmonic wave-generating device which includes a solid laser light source such as a DFB semiconductor laser or a fiber laser, a light-amplifying section having a fiber amplifier or the like, and a wavelength-converting section, etc. and which outputs a pulse light beam having a wavelength of 193 nm as disclosed, for example, in International Publication No. 1999/46835 (corresponding to United States Patent No. 7,023,610). Further, in the respective embodiments described above, the projection area (exposure area) is rectangular. However, it is also allowable to adopt other shape including, for example, circular arc-shaped, trapezoidal, parallelogramic, and rhombic shapes.

As described above, the exposure apparatus EX according to the embodiment described above is produced by assembling the various subsystems including the respective constitutive elements as defined in claims so that the predetermined mechanical accuracy, electric accuracy and optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include the mechanical connection, the wiring connection of the electric circuits, the piping connection of the air pressure circuits in correlation with the various subsystems, etc. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which the temperature, the cleanness, etc. are managed.

As for various United States Patents and United States Patent Application Publications, etc. referred to in this specification, the contents thereof are incorporated herein by reference within a range of permission of the domestic laws and ordinances of the designated state or the selected state, in relation to those other than those having been specifically and explicitly incorporated herein by reference as well.
It is a matter of course that the present invention is not limited to the embodiments described above, and may be embodied in other various forms within a range without deviating from the gist or essential characteristics of the present invention. All of the contents of the disclosure of Japanese Patent Application No. 2006-182561 filed on June 30, 2006 including the specification, claims, drawings, and abstract are cited and incorporated in this application exactly as they are.

### INDUSTRIAL APPLICABILITY

According to the present invention, it is possible to efficiently perform the maintenance for the exposure apparatus which performs the exposure in accordance with the liquid immersion method. Therefore, the amount of the foreign matter in the liquid of the liquid immersion area is decreased during the exposure to be performed thereafter, and it is possible to produce the device highly accurately.

## Claims

1. A maintenance method for an exposure apparatus which forms a liquid immersion space by filling a first liquid between an optical member and a substrate and which exposes the substrate with an exposure light via the optical member and the first liquid, the maintenance method comprising:
a moving step of arranging a movable member to be opposite to a liquid immersion space-forming member which forms the liquid immersion space with the first liquid;
a liquid immersion step of forming the liquid immersion space, with the first liquid, on the movable member by using the liquid immersion space-forming member; and
a cleaning step of jetting a second liquid toward an area including at least a part of a liquid contact portion, which comes into contact with the first liquid, from a side of the movable member to clean the liquid contact portion.

2. The maintenance method according to claim 1, wherein the liquid immersion step and the cleaning step are executed concurrently at least partially.

3. The maintenance method according to claim 1 or 2, wherein the second liquid is jetted from a jet nozzle in the cleaning step.

4. The maintenance method according to any one of claims 1 to 3, wherein the second liquid is jetted while being mixed with a gas in the cleaning step.

5. The maintenance method according to any one of claims 1 to 4, further comprising a recovery step of recovering the second liquid.

6. The maintenance method according to any one of claims 1 to 5, wherein the first liquid is different from the second liquid.

7. The maintenance method according to any one of claims 1 to 6, wherein the second liquid includes the first liquid.

8. The maintenance method according to claim 7, wherein the second liquid is obtained by mixing the first liquid with a gas or a solvent.

9. The maintenance method according to any one of claims 1 to 5, wherein the second liquid is same as the first liquid.

10. The maintenance method according to any one of claims 7 to 9, wherein the first liquid is supplied to the side of the movable member via the liquid immersion space-forming member.

11. A maintenance method for an exposure apparatus which forms a liquid immersion space by filling a first liquid between an optical member and a substrate and which exposes the substrate with an exposure light via the optical member and the first liquid, the maintenance method comprising:
a moving step of arranging a movable member to be opposite to a liquid immersion space-forming member which forms the liquid immersion space with the first liquid;
an accumulating step of supplying the first liquid onto the movable member by using the liquid immersion space-forming member to accumulate the supplied first liquid; and
a cleaning step of jetting the first liquid accumulated in the accumulating step toward an area including at least a part of a liquid contact portion, which comes into contact with the first liquid, to clean the liquid contact portion.

12. The maintenance method according to claim 11, wherein the first liquid accumulated in the accumulating step is jetted from a jet nozzle in the cleaning step.

13. The maintenance method according to claim 11 or 12, wherein the accumulating step and the cleaning step are executed concurrently at least partially.

14. The maintenance method according to any one of claims 1 to 13, wherein at least a passage port, for the first liquid, of the liquid immersion space-forming member is cleaned in the cleaning step.

15. The maintenance method according to claim 14, wherein the liquid immersion space-forming member has at least one of a supply port and a recovery port for the first liquid, and the passage port includes at least one of the supply port and the recovery port.

16. The maintenance method according to any one of claims 1 to 15, wherein at least a porous member of the liquid immersion space-forming member is cleaned in the cleaning step.

17. The maintenance method according to claim 16, wherein the porous member is provided on a recovery port or a recovery flow passage, for the first liquid, of the liquid immersion space-forming member.

18. The maintenance method according to any one of claims 1 to 17, wherein the liquid immersion space-forming member is arranged to surround the optical member.

19. The maintenance method according to claim 18, wherein the exposure apparatus includes a projection optical system in which the optical member is arranged closest to an image plane.

20. A maintenance method for an exposure apparatus which exposes a substrate with an exposure light via an optical member and a first liquid, the maintenance method comprising: arranging a movable member to be opposite to a nozzle member having a liquid contact portion, which comes into contact with the first liquid, and retaining the first liquid between the optical member and the substrate; and cleaning the liquid contact portion by using a second liquid supplied to the movable member via the nozzle member.

21. The maintenance method according to claim 20, wherein the liquid contact portion is cleaned by jetting the second liquid from the movable member.

22. The maintenance method according to claim 20 or 21, wherein a liquid immersion area is formed between the optical member and the movable member during the cleaning.

23. The maintenance method according to claim 22, wherein the liquid immersion area is formed with the second liquid.

24. The maintenance method according to any one of claims 20 to 23, wherein the second liquid, which is supplied to the movable member, is accumulated, and the accumulated second liquid is directed toward the liquid contact portion.

25. A maintenance method for an exposure apparatus which exposes a substrate with an exposure light via an optical member and a first liquid, the maintenance method comprising: arranging a movable member to be opposite to a nozzle member which retains the first liquid between the optical member and the substrate; and setting a cleaning condition for cleaning a liquid contact portion, which comes into contact with the first liquid, with a second liquid, depending on information about the liquid contact portion.

26. The maintenance method according to claim 25, wherein the information includes information about at least one of a state and a position of a cleaning objective area of the liquid contact portion.

27. The maintenance method according to claim 26, wherein the information includes information about contamination of the cleaning objective area.

28. The maintenance method according to any one of claims 25 to 27, wherein the cleaning condition is variable depending on the information.

29. The maintenance method according to any one of claims 25 to 28, wherein the cleaning condition includes a characteristic of the second liquid.

30. The maintenance method according to any one of claims 25 to 29, wherein the second liquid is jetted toward the liquid contact portion, and the cleaning condition includes a jetting condition of the second liquid.

31. The maintenance method according to any one of claims 20 to 30, wherein the second liquid includes the first liquid.

32. The maintenance method according to claim 31, wherein the second liquid is obtained by mixing the first liquid with a gas or a solvent.

33. The maintenance method according to any one of claims 20 to 31, wherein the second liquid is same as the first liquid.

34. The maintenance method according to any one of claims 20 to 31, wherein the second liquid is different from the first liquid.

35. The maintenance method according to any one of claims 20 to 34, wherein at least a passage port, for the first liquid, which is included in the liquid contact portion of the nozzle member is cleaned.

36. The maintenance method according to any one of claims 20 to 35, wherein the nozzle member has at least one of a supply port and a recovery port for the first liquid, and at least one of the supply port and the recovery port is cleaned.

37. The maintenance method according to any one of claims 20 to 36, wherein at least a porous member, which is included in the liquid contact portion of the nozzle member, is cleaned.

38. The maintenance method according to claim 37, wherein the porous member is provided on a recovery port or a recovery flow passage, for the first liquid, of the nozzle member.

39. The maintenance method according to any one of claims 20 to 38, wherein a liquid contact portion which comes into contact with the first liquid and which is different from that of the nozzle member, is also cleaned.

40. The maintenance method according to claim 39, wherein the liquid contact portion, which is different from that of the nozzle member, includes at least the optical member.

41. The maintenance method according to any one of claims 20 to 40, wherein the nozzle member is arranged while surrounding the optical member, and the exposure apparatus includes a projection optical system in which the optical member is arranged closest to an image plane.

42. The maintenance method according to any one of claims 1 to 41, wherein the liquid contact portion includes an area which is liquid-attractive with respect to the first liquid.

43. The maintenance method according to any one of claims 1 to 42, wherein the movable member is different from a movable member which is capable of holding the substrate.

44. An exposure method for exposing a substrate with an exposure light via an optical member and a first liquid, the exposure method comprising:
a step of using the maintenance method as defined in any one of claims 1 to 43.

45. An exposure method for exposing a substrate with an exposure light via an optical member and a first liquid, the exposure method comprising: arranging a movable member to be opposite to a nozzle member having a liquid contact portion, which comes into contact with the first liquid, and retaining the first liquid between the optical member and the substrate; and cleaning the liquid contact portion by using a second liquid supplied to the movable member via the nozzle member.

46. An exposure method for exposing a substrate with an exposure light via an optical member and a first liquid, the exposure method comprising: arranging a movable member to be opposite to a nozzle member which retains the first liquid between the optical member and the substrate; and setting a cleaning condition for cleaning a liquid contact portion, which comes into contact with the first liquid, with a second liquid, depending on information about the liquid contact portion.

47. A method for producing a device, comprising:
exposing a substrate by using the exposure method as defined in any one of claims 44 to 46; and
developing the exposed substrate.

48. An exposure apparatus which forms a liquid immersion space by filling a first liquid between an optical member and a substrate and which exposes the substrate with an exposure light via the optical member and the first liquid, the exposure apparatus comprising:
a liquid immersion space-forming member which forms the liquid immersion space with the first liquid;
a movable member which is movable relative to the optical member;
a liquid-jetting mechanism at least a part of which is provided on the movable member and which jets a second liquid; and
a controller which allows the liquid-jetting mechanism to jet the second liquid therefrom toward an area including at least a part of a liquid contact portion, which comes into contact with the first liquid, to clean the liquid contact portion when the liquid immersion space is formed with the first liquid on the movable member via the liquid immersion space-forming member.

49. The exposure apparatus according to claim 48, wherein the liquid-jetting mechanism includes a jet nozzle which jets the second liquid.

50. The exposure apparatus according to claim 48 or 49, wherein the liquid-jetting mechanism includes a mixer which mixes the second liquid with a gas.

51. The exposure apparatus according to any one of claims 48 to 50, further comprising a liquid recovery mechanism which recovers the second liquid.

52. The exposure apparatus according to any one of claims 48 to 51, wherein the first liquid is different from the second liquid.

53. The exposure apparatus according to any one of claims 48 to 52, wherein the second liquid includes the first liquid.

54. The exposure apparatus according to claim 53, wherein the second liquid is obtained by mixing the first liquid with a gas or a solvent.

55. The exposure apparatus according to any one of claims 48 to 51, wherein the second liquid is same as the first liquid.

56. The exposure apparatus according to any one of claims 53 to 55, wherein the first liquid is supplied to a side of the movable member via the liquid immersion space-forming member.

57. An exposure apparatus which forms a liquid immersion space by filling a first liquid between an optical member and a substrate and which exposes the substrate with an exposure light via the optical member and the first liquid, the exposure apparatus comprising:
a liquid immersion space-forming member which forms the liquid immersion space with the first liquid;
a movable member which is movable relative to the optical member;
an accumulating mechanism which accumulates the first liquid supplied onto the movable member via the liquid immersion space-forming member; and
a liquid-jetting device at least a part of which is provided on the movable member and which jets the first liquid accumulated by the accumulating mechanism toward an area including at least a part of a liquid contact portion, which comes into contact with the first liquid, to clean the liquid contact portion.

58. The exposure apparatus according to claim 57, wherein the liquid-jetting device includes a jet nozzle which jets the first liquid accumulated by the accumulating mechanism; and
the accumulating mechanism includes a check valve which prevents the first liquid from backflowing toward the liquid immersion space-forming member.

59. The exposure apparatus according to any one of claims 48 to 58, wherein the liquid contact portion includes at least a passage port, for the first liquid, of the liquid immersion space-forming member.

60. The exposure apparatus according to claim 59, wherein the liquid immersion space-forming member has at least one of a supply port and a recovery port for the first liquid, and the passage port includes at least one of the supply port and the recovery port.

61. The exposure apparatus according to any one of claims 48 to 60, wherein the liquid contact portion includes at least a porous member of the liquid immersion space-forming member.

62. The exposure apparatus according to claim 61, wherein the porous member is provided on a recovery port or a recovery flow passage, for the first liquid, of the liquid immersion space-forming member.

63. The exposure apparatus according to any one of claims 48 to 62, wherein a porous member is provided fixedly or exchangeably on a passage port, for the first liquid, of the liquid immersion space-forming member.

64. The exposure apparatus according to claim 63, wherein the porous member is exchangeable, and all of the first liquid is discharged from a flow passage thereof when the porous member is exchanged.

65. The exposure apparatus according to any one of claims 48 to 64, wherein the liquid immersion space-forming member is arranged to surround the optical member.

66. The exposure apparatus according to claim 65, further comprising a projection optical system in which the optical member is arranged closest to an image plane.

67. An exposure apparatus which exposes a substrate with an exposure light via an optical member and a first liquid, the exposure apparatus comprising:
a nozzle member having a liquid contact portion, which comes into contact with the first liquid, and retaining the first liquid between the optical member and the substrate;
a movable member which is movable relative to the optical member; and
a cleaning member at least a part of which is provided on the movable member and which cleans the liquid contact portion with a second liquid supplied to the movable member via the nozzle member.

68. The exposure apparatus according to claim 67, wherein the cleaning member cleans the liquid contact portion by jetting the second liquid from the movable member.

69. The exposure apparatus according to claim 67 or 68, wherein a liquid immersion area is formed between the optical member and the movable member by the nozzle member during the cleaning.

70. The exposure apparatus according to claim 69, wherein the liquid immersion area is formed with the second liquid.

71. The exposure apparatus according to any one of claims 67 to 70, further comprising an accumulating portion which accumulates the second liquid supplied to the movable member, wherein the cleaning member directs the accumulated second liquid toward the liquid contact portion.

72. An exposure apparatus which exposes a substrate with an exposure light via an optical member and a first liquid, the exposure apparatus comprising:
a nozzle member which retains the first liquid between the optical member and the substrate;
a cleaning member which cleans a liquid contact portion, coming into contact with the first liquid, with a second liquid;
a movable member which is arranged to be opposite to the nozzle member at least during the cleaning; and
a controller which controls the cleaning member to make a cleaning condition with the second liquid be variable, and which sets the cleaning condition depending on information about the liquid contact portion.

73. The exposure apparatus according to claim 72, wherein the information includes information about at least one of a state and a position of a cleaning objective area of the liquid contact portion.

74. The exposure apparatus according to claim 73, wherein the information includes information about contamination of the cleaning objective area.

75. The exposure apparatus according to any one of claims 72 to 74, wherein the cleaning condition includes a characteristic of the second liquid.

76. The exposure apparatus according to any one of claims 72 to 75, wherein the cleaning member jets the second liquid toward the liquid contact portion, and the cleaning condition includes a jetting condition of the second liquid.

77. The exposure apparatus according to any one of claims 67 to 76, wherein the second liquid includes the first liquid.

78. The exposure apparatus according to claim 77, wherein the second liquid is obtained by mixing the first liquid with a gas or a solvent.

79. The exposure apparatus according to any one of claims 67 to 77, wherein the second liquid is same as the first liquid.

80. The exposure apparatus according to any one of claims 67 to 77, wherein the second liquid is different from the first liquid.

81. The exposure apparatus according to any one of claims 67 to 80, wherein at least a passage port, for the first liquid, which is included in the liquid contact portion of the nozzle member is cleaned.

82. The exposure apparatus according to any one of claims 67 to 81, wherein the nozzle member has at least one of a supply port and a recovery port for the first liquid, and at least one of the supply port and the recovery port is cleaned.

83. The exposure apparatus according to any one of claims 67 to 82, wherein at least a porous member, which is included in the liquid contact portion of the nozzle member, is cleaned.

84. The exposure apparatus according to claim 83, wherein the porous member is provided on a recovery port or a recovery flow passage, for the first liquid, of the nozzle member.

85. The exposure apparatus according to any one of claims 67 to 83, wherein the nozzle member has a porous member which is fixed to a passage port for the first liquid or which is provided exchangeably on the passage port.

86. The exposure apparatus according to any one of claims 67 to 85, wherein the cleaning member also cleans a liquid contact portion which comes into contact with the first liquid and which is different from that of the nozzle member.

87. The exposure apparatus according to claim 86, wherein the liquid contact portion, which is different from that of the nozzle member, includes at least the optical member.

88. The exposure apparatus according to any one of claims 67 to 87, further comprising a projection optical system in which the optical member is arranged closest to an image plane, wherein the nozzle member is arranged while surrounding the optical member.

89. The exposure apparatus according to any one of claims 48 to 88, wherein the liquid contact portion includes an area which is liquid-attractive with respect to the first liquid.

90. The exposure apparatus according to any one of claims 48 to 89, wherein the movable member is different from a movable member which is capable of holding the substrate.

91. The exposure apparatus according to any one of claims 48 to 89, wherein the movable member is a substrate stage which is capable of holding the substrate or a stage which is movable independently from the substrate stage.

92. A method for producing a device, comprising:
exposing a substrate by using the exposure apparatus as defined in any one of claims 48 to 91; and
developing the exposed substrate.
